# EUROPEAN PATENT APPLICATION

(11) **EP 4 458 758 A1**
(43) Date of publication of application: **06.11.2024**
(21) Application number: 22915980.1
(22) Date of filing: 23.12.2022
(51) Int. Cl.: B81B 1/00, B81C 1/00

(54) **MICROFLUIDIC CHIP AND METHOD FOR MANUFACTURING MICROFLUIDIC CHIP**

(30) Priority: 28.12.2021 JP 2021214520
(71) Applicant: Toppan Holdings Inc., Tokyo 110-0016 (JP)
(72) Inventor: YAZAWA, Hiroko, Tokyo 110-0016 (JP); FUKUGAMI, Norihito, Tokyo 110-0016 (JP)
(74) Representative: Plasseraud IP
(86) International application number: PCT/JP2022/047765
(87) International publication number: WO 2023/127757

(57) **Abstract**

A microfluidic chip that can enhance adhesion between a wall and a substrate, and a method of producing the microfluidic chip are provided. A microfluidic chip (1) includes a substrate (10), a partition layer (11) made of a resin material, the partition layer (11) being disposed on the substrate (10) and defining a fluidic channel portion (3), and a cover layer (12) disposed on a side of the partition layer (11) opposite to that facing the substrate (10), the cover layer (12) covering the fluidic channel portion (3), wherein the partition layer (11) has a width which increases toward the substrate (10) in cross-sectional view.

## Description

### [Technical Field]

The present disclosure relates to microfluidic chips and methods of producing the same.

### [Background Art]

In recent years, technologies have been proposed in which micro reaction fields are formed by applying lithography processing or thick film processing technologies to enable testing in units of several microliters to several nanoliters. Technologies using such a micro reaction field are called µ-TAS (micro total analysis systems).

µ-TAS is applied to fields such as genetic testing, chromosome testing, cell testing and drug development, biotechnologies, testing of trace substances in the environment, investigation of breeding environments for agricultural products, genetic testing of agricultural products, and the like. The introduction of µ-TAS technologies brings significant effects such as automation, higher speed, higher accuracy, lower cost, speed, reduced environmental impact, and the like.

In µ-TAS, micrometer-sized fluidic channels (micro fluidic channels, micro channels) formed on a substrate are often used, and such a substrate is called a chip, microchip, microfluidic chip, or the like.

Conventionally, such microfluidic chips have been produced using techniques such as injection molding, molding, cutting, etching, and the like. As the substrates of microfluidic chips, glass substrates are typically used since they are easy to produce and suitable for optical detection. Meanwhile, microfluidic chips using resin materials, which are lightweight, less likely to break than glass substrates, and inexpensive, are being developed. As a method of producing a microfluidic chip using a resin material, a resin pattern for a fluidic channel is formed typically by photolithography, and a lid material is bonded thereto to form a microfluidic chip. According to this method, microfluidic channel patterns, which have been sometimes difficult to produce with conventional techniques, can be formed.

Such microfluidic chips are formed by bonding a plurality of members together. For example, PTL 1 discloses a microfluidic chip produced by bonding members together via an adhesive. Further, as described in PTL 2 for example, a method has been proposed in which a process gas is turned into plasma at or near atmospheric pressure to modify a substrate surface, and the substrate is bonded without using an adhesive (e.g., PTL 2).

### [Citation List]

### [Patent Literature]

PTL 1: JP 2007-240461 A
PTL 2: JP 2011-104886 A

### [Summary of Invention]

### [Technical Problem]

As the recent fluidic channel pattern structures have become more complex, the surface area of the fluidic channel portion (space portion) in microfluidic chips increases, inevitably reducing a region (bonding region) for bonding the wall and the substrate. Even for microfluidic chips having a complex fluidic channel pattern, there is a need to enhance adhesion between the wall and the substrate from the perspective of preventing occurrence of liquid leakage, damage, and the like during use.

In view of the above problems, the present disclosure has been made to provide a microfluidic chip that can enhance adhesion between the wall and the substrate, and a method of producing the microfluidic chip.

### [Solution to Problems]

In order to solve the above problems, a microfluidic chip according to an aspect of the present disclosure includes: a substrate; a partition member made of a resin material, the partition member being disposed on the substrate and defining a fluidic channel; and a cover member disposed on a side of the partition member opposite to that facing the substrate, the cover member covering the fluidic channel, wherein the partition member has a width which increases toward the substrate in cross-sectional view.

A method of producing a microfluidic chip according to another aspect of the present disclosure includes the steps of: applying a resin to a substrate; exposing the applied resin to light; subjecting the exposed resin to development and cleaning to thereby form a partition member that defines a fluidic channel on the substrate; post-baking the partition member; and bonding a cover member to a side of the partition member opposite to that facing the substrate, wherein excess resin on the substrate is removed by the development, whereby the partition member is formed to have a width which increases toward the substrate in cross-sectional view.

### [Advantageous Effects of the Invention]

According to the aspects of the present disclosure, a microfluidic chip that can enhance adhesion between the wall and the substrate can be provided.

### [Brief Description of the Drawings]

Fig. 1 is a schematic diagram illustrating an example configuration of a microfluidic chip according to a first embodiment of the present disclosure, in which (a) is a schematic plan view of an example configuration of a microfluidic chip according to a first embodiment of the present disclosure, and (b) is a schematic cross-sectional diagram of an example configuration of a microfluidic chip according to a first embodiment of the present disclosure.
Fig. 2 is a flowchart showing an example method of producing a microfluidic chip according to the first embodiment of the present disclosure.
Fig. 3 is a schematic cross-sectional diagram illustrating an example configuration of a microfluidic chip according to a first modified example of the first embodiment of the present disclosure.
Fig. 4 is a schematic cross-sectional diagram illustrating an example configuration of a microfluidic chip according to a second modified example of the first embodiment of the present disclosure.
Fig. 5 is a line graph showing an example of light transmittance of a photosensitive resin layer.
Fig. 6 is a schematic cross-sectional diagram illustrating an example configuration of a microfluidic chip according to a second embodiment of the present disclosure.
Fig. 7 is a schematic cross-sectional diagram illustrating an example configuration of a microfluidic chip according to a first modified example of the second embodiment of the present disclosure.
Fig. 8 is a schematic cross-sectional diagram illustrating an example configuration of a microfluidic chip according to a second modified example of the second embodiment of the present disclosure.
Fig. 9 is a schematic plan view of an adhesion evaluation sample in Test example 1 of the present disclosure as seen from above.
Fig. 10 is a schematic cross-sectional diagram illustrating a pillar pattern structure of an adhesion evaluation sample in Test example 1 of the present disclosure.
Fig. 11 is a schematic plan view of an adhesion evaluation sample in Test example 2 of the present disclosure as seen from above.
Fig. 12 is a schematic cross-sectional diagram illustrating a pillar pattern structure of an adhesion evaluation sample in Test example 2 of the present disclosure.
Fig. 13 is a schematic plan view of a region in which test cuts are made in an adhesion evaluation sample of Test example 1 shown in Fig. 9.
Fig. 14 is a schematic plan view illustrating an adhesion test method in an adhesion evaluation sample of Test example 1 of the present disclosure.
Fig. 15 is a schematic cross-sectional diagram illustrating an adhesion test method in Test example 1 of the present disclosure.
Fig. 16 is a schematic plan view illustrating an adhesion test method in an adhesion evaluation sample of Test example 2 shown in Fig. 11.
Fig. 17 is a schematic cross-sectional diagram illustrating an adhesion test method in Test example 2 of the present disclosure.

### [Description of the Embodiment]

The present disclosure will be described through embodiments, but the following embodiments do not limit the invention defined in the appended claims. Further, not all of the combinations of features described in the embodiments are essential for the solution of the invention. The drawings schematically illustrate the invention defined in the appended in the claims, and dimensions such as the width, thickness, and the like of each component may differ from the actual ones, and the ratios thereof may also differ from the actual ones.

The following description will be given of a microfluidic chip according to a first embodiment of the present disclosure. In the following description, a substrate side of the microfluidic chip may be referred to as "lower side", and a side (lid material side) of the microfluidic chip opposite to that facing the substrate may be referred to as "upper side".

The inventors of the present invention have diligently studied and found that, in microfluidic chips, the area of the bonding region for bonding a wall and a substrate to each other can be increased by forming the wall into a specific shape. Accordingly, the inventors have invented a microfluidic chip which can enhance adhesion strength between the wall and the lid material, and a method of producing the microfluidic chip.

With reference to the drawings, embodiments of the present disclosure will be described below.

### 1. First Embodiment

### (1.1) Basic configuration of microfluidic chip

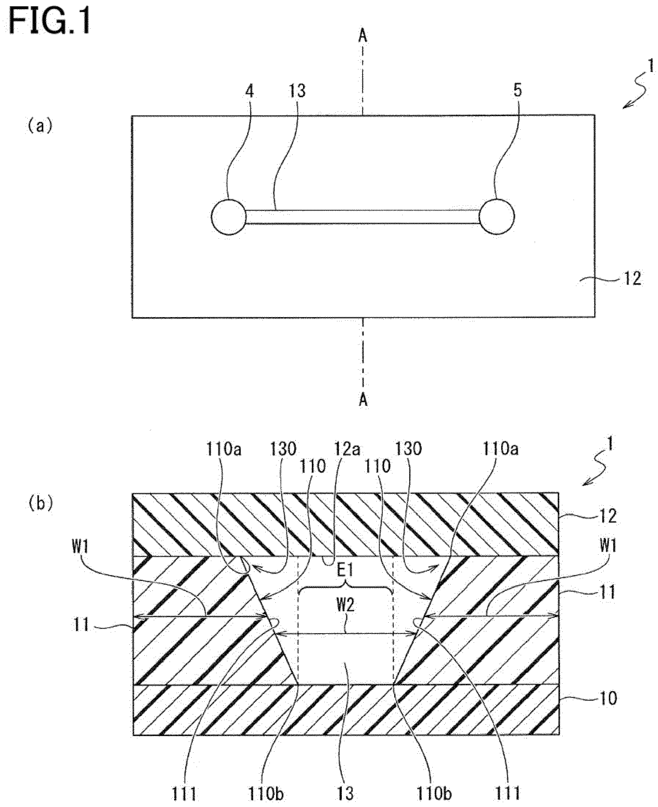

Fig. 1 is a schematic diagram illustrating an example configuration of a microfluidic chip 1 according to a first embodiment of the present disclosure (hereinafter, also referred to as "the present embodiment"). Specifically, Fig. 1(a) is a schematic plan view of the microfluidic chip 1 of the present embodiment. Fig. 1(b) is a schematic cross-sectional diagram illustrating a cross-section of the microfluidic chip 1 taken along the line A-A in Fig. 1(a).

As shown in Fig. 1(a), the microfluidic chip 1 includes an inlet 4 for introducing a fluid (for example, liquid), a fluidic channel portion 13 through which the fluid introduced through the inlet 4 flows, and an outlet 5 for discharging the fluid from the fluidic channel portion 13. In the microfluidic chip 1, the fluidic channel portion 13 is covered with a cover layer 12, and the inlet 4 and the outlet 5 are through holes formed in the cover layer 12. Details of the cover layer 12 will be described later.

Fig. 1(a) shows the fluidic channel portion 13 as seen through the transparent cover layer 12.

In the microfluidic chip 1, at least one inlet 4 and at least one outlet 5 may be provided, and a plurality of each may be provided. Further, in the microfluidic chip 1, a plurality of fluidic channel portions 13 may be provided, and the fluidic channel portions 13 may be designed to merge or branch the fluid introduced from the inlet 4.

In the following description, details of the members constituting the fluidic channel portion 13 in the microfluidic chip 1 will be described. As shown in Fig. 1(b), the microfluidic chip 1 includes a substrate 10, a partition layer (an example of partition member) 11 provided on the substrate 10 and defining the fluidic channel, and a cover layer (an example of cover member) 12 provided on a side of the partition layer 11 opposite to that facing the substrate 10 and covering the fluidic channel portion 13. The fluidic channel portion 13 through which the fluid introduced from the inlet 4 flows is a region surrounded by the substrate 10, the partition layer 11 and the cover layer 12. The fluidic channel portion 13 is defined by a pair of partition layers 11 facing each other provided on the substrate 10, and a side of the fluidic channel portion 13 opposite to that facing the substrate 10 is covered with the cover layer 12 as a lid material. As described above, a fluid is introduced into the fluidic channel portion 13 from the inlet 4 (see Fig. 1(a)) formed in the cover layer 12, and the fluid that has flowed through the fluidic channel portion 13 is discharged from the outlet 5.

Although details will be described later, the partition layer 11 in the present embodiment has a width W1 that increases toward the substrate 10 in cross-sectional view. That is, the width W1 of the partition layer 11 in cross-sectional view increases toward the substrate 10. With this configuration, in the microfluidic chip 1, the area of the bonding region for bonding the wall and the substrate can be increased, enhancing adhesion between the partition layer 11 and the substrate 10.

### (1.1.1) Substrate

The substrate 10 is a member that serves as a base of the microfluidic chip 1, and the partition layer 11 provided on the substrate 10 defines the fluidic channel portion 13. That is, the substrate 10 and the partition layer 11 can be regarded as a main body of the microfluidic chip 1.

The substrate 10 can be made of either a translucent material or a non-translucent material. For example, when the state inside the fluidic channel portion 13 (state of fluid) is detected and observed using light, a material having excellent transparency to the light can be used. As the translucent material, resin, glass, or the like can be used. Examples of the resin used for the translucent material constituting the substrate 10 include acrylic resin, methacrylic resin, polypropylene, polycarbonate resin, cycloolefin resin, polystyrene resin, polyester resin, urethane resin, silicone resin and fluororesin from the viewpoint of being suitable for forming the main body of the microfluidic chip 1.

Further, for example, when the state inside the fluidic channel portion 13 (state of fluid) is not necessarily detected and observed using light, a non-translucent material may be used. Examples of the non-translucent material include silicon wafers and copper plates. Although the thickness of the substrate 10 is not particularly limited, it is preferably in the range of 10 µm (0.01 mm) or greater and 10 mm or less since a certain degree of rigidity is required in formation of a fluidic channel.

### (1.1.2) Partition layer

The partition layer 11 is disposed on the substrate and forms a fluidic channel portion 13. The partition layer 11 can be made of a resin material. Examples of the resin material of the partition layer 11 include a photosensitive resin.

The photosensitive resin constituting the partition layer 11 is preferably photosensitive to light having a wavelength of 190 nm or greater and 400 nm or less, which is in the ultraviolet light region. As the photosensitive resin, a photoresist such as liquid resist or dry film resist can be used. The photosensitive resin may be either positive type in which the photosensitive region dissolves or negative type in which the photosensitive region becomes insoluble. Examples of the photosensitive resin composition suitable for forming the partition layer 11 in the microfluidic chip 1 include radical negative type photosensitive resins containing alkali-soluble polymers, addition polymerizable monomers and photopolymerization initiators. Examples of the photosensitive resin material include acrylic resins, acrylic urethane resins (urethane acrylate resins), epoxy resins, polyamide resins, polyimide resins, polyurethane resins, polyester resins, polyether resins, polyolefin resins, polycarbonate resins, polystyrene resins, norbornene resins, phenol novolac resins, and other photosensitive resins, and these can be used singly, or in combinations or as copolymers of two or more.

In the present embodiment, the resin material of the partition layer 11 is not limited to a photosensitive resin, and may be, for example, silicone rubber (PDMS: polydimethylsiloxane) or synthetic resin. Examples of the synthetic resin include polymethyl methacrylate resin (PMMA), polycarbonate (PC), polystyrene resin (PS), polypropylene (PP), cycloolefin polymer (COP) and cycloolefin copolymer (COC). The resin material of the partition layer 11 is preferably selected as appropriate according to the application.

Further, the thickness of the partition layer 11 on the substrate 10, that is, the height of the fluidic channel portion 13, is not particularly limited, but is required to be greater than the substances to be analyzed or inspected (for example, drugs, bacteria, cells, red blood cells, leukocytes, etc.) contained in the fluid introduced into the fluidic channel portion 13. Therefore, the thickness of the partition layer 11, that is, the height of the fluidic channel portion 13, is preferably in the range of 5 µm or greater and 100 µm or less.

Similarly, since the width of the fluidic channel portion 13 is required to be greater than the substances to be analyzed or inspected, the width of the fluidic channel portion 13 defined by the partition layer 11 is preferably in the range of 5 µm or greater and 100 µm or less. Further, in order to ensure sufficient reaction time for the reaction solution, the length of the fluidic channel defined by the partition layer 11 is preferably in the range of 10 mm or greater and 100 mm or less, more preferably in the range of 30 mm or greater and 70 mm or less, and still more preferably in the range of 40 mm or greater and 60 mm or less.

### (1.1.3) Cover Layer

In the microfluidic chip 1 in the present embodiment, the cover layer 12 is a lid material covering the fluidic channel portion 13 as shown in Fig. 1(b). As described above, the cover layer 12 is provided on a side of the partition layer 11 opposite to that facing the substrate 10, and the cover layer 12 faces the substrate 10 with the partition layer 11 therebetween. More specifically, as shown in Fig. 1(b), the cover layer 12 in cross-sectional view has side portions supported by the partition layer 11 and a center region that faces the substrate 10, the center region defining the upper side of the fluidic channel portion 13.

The cover layer 12 can be made of either a translucent material or a non-translucent material For example, when the state inside the fluidic channel is detected and observed using light, a material having excellent transparency to the light can be used. As the translucent material, resin, glass, or the like can be used. Examples of the resin constituting the cover layer 12 include acrylic resin, methacrylic resin, polypropylene, polycarbonate resin, cycloolefin resin, polystyrene resin, polyester resin, urethane resin, silicone resin and fluororesin from the viewpoint of being suitable for forming the main body of the microfluidic chip 1. The thickness of the cover layer 12 is not particularly limited, but in view of forming through holes corresponding to the inlet 4 and the outlet 5 in the cover layer 12, it is preferably in the range of 10 µm or greater and 10 mm or less. Further, it is also preferred that holes corresponding to the inlet 4 for introducing a fluid (liquid) and the outlet 5 for discharging a fluid are formed in advance in the cover layer 12 before the cover layer 12 is bonded to the partition layer 11.

### (1.1.4) Shape of partition layer and configuration of fluidic channel

In the following description, details of the shape of the partition layer 11 and the configuration of the fluidic channel portion 13 in the microfluidic chip 1 according to the present embodiment will be described. First, the shape of the partition layer 11 that defines the fluidic channel portion 13 will be described.

### (1.1.4.1) Shape of partition layer

As shown in Fig. 1(b), the width W1 of the partition layer 11 of the microfluidic chip 1 increases toward the substrate 10 in cross-sectional view. The "cross-section" in the "cross-sectional view" refers to a cross-section of the microfluidic chip 1 cut in the thickness direction (direction perpendicular to the longitudinal direction of the fluidic channel portion 13), for example, and the cross-section includes at least the substrate 10, the partition layer 11 and the fluidic channel portion 13.

In the microfluidic chip 1, the width W1 of the partition layer 11 increases toward the substrate 10, whereby the area of the bonding region for bonding the partition layer 11 and the substrate 10 can be increased, enhancing adhesion between the partition layer 11 and the substrate 10. This can prevent occurrence of liquid leakage, damage, and the like during use of the microfluidic chip 1. In the following description, the shape of the partition layer 11 will be more specifically described.

The partition layer 11 of the microfluidic chip 1 includes a side surface 110 that defines the fluidic channel portion 13. The side surface 110 is connected to the cover layer 12 at an upper end 110a which is an end on the cover layer 12 side. Further, the side surface 110 is connected to the substrate 10 at a lower end 110b which is an end on the substrate 10 side. As shown in Fig. 1(b), the side surface 110 has an inclined surface 111 that is inclined relative to the substrate 10.

The inclined surface 111 will be specifically described below. As shown in Fig. 1(b), the inclined surface 111 has a planar shape. Further, in the partition layer 11 of the microfluidic chip 1 according to the present embodiment, the inclined surface 111 is provided on the entire side surface 110. More specifically, the inclined surface 111 extends from the upper end 110a to the lower end 110b of the side surface 110, and is connected to the cover layer 12 at the upper end 110a of 10 and to the substrate 10 at the lower end 110b. That is, the upper end 110a is the upper end of the side surface 110 and the inclined surface 111, and the lower end 110b is the lower end of the side surface 110 and the inclined surface 111.

As shown in Fig. 1(b), in the partition layer 11, the lower end 110b of the side surface 110 (lower end of the inclined surface 111) is located closer to the center of the fluidic channel portion 13 than the upper end 110a is. That is, the lower end 110b of the side surface 110 (lower end of the inclined surface 111) is located closer to the opposing partition layer 11 than the upper end 110a is. In other words, in the partition layer 11, the upper end 110a of the side surface 110 (upper end of the inclined surface 111) is located further away from the center of the fluidic channel portion 13 than the lower end 110b is. That is, the upper end 110a of the side surface 110 (upper end of the inclined surface 111) is located further away from the opposing partition layer 11 than the lower end 110b is.

The inclined surface 111 extends downward in an inclined manner from the upper end 110a connected to the cover layer 12 to the lower end 110b, where it is connected to the substrate 10. Thus, the width W1 of the partition layer 11 in cross-sectional view increases in the direction toward the center of the fluidic channel portion 13, that is, toward the opposing partition layer 11 in the transverse direction of the fluidic channel portion 13, as it approaches the substrate 10. Therefore, the width W1 of the partition layer 11 in cross-sectional view increases toward the substrate 10.

As described above, the inclined surface 111 has a planar shape and is provided on the entire side surface 110 of the partition layer 11. Thus, the width W1 of the partition layer 11 continuously increases toward the substrate 10. Specifically, the width W1 of the partition layer 11 continuously expands and increases toward the center of the fluidic channel portion 13 (in the transverse direction), as it approaches the substrate 10. The "continuously increases (expands)" herein means that the width W1 of the partition layer 11 continuously increases (expands), without decreasing (reducing), from the upper end 110a where the inclined surface 111 is connected to the cover layer 12 to the lower end 110b where the inclined surface 111 is connected to the substrate 10. With this configuration, in the microfluidic chip 1, the area of the bonding region for bonding the partition layer 11 and the substrate 10 can be reliably increased, further reliably enhancing adhesion between the partition layer 11 and the substrate 10.

### (1.1.4.2) Configuration of fluidic channel portion

Next, the configuration of the fluidic channel portion 13 defined by the substrate 10, the partition layer 11 and the cover layer 12 will be described.

The fluidic channel portion 13 has a fluidic channel width W2 defined as the width between a pair of partition layers 11 facing each other, that is, the width between the side surfaces 110. In the present embodiment, the inclined surface 111 is provided on the entire side surface 110, so the fluidic channel width W2 can also be defined as the width between the inclined surfaces 111. As described above, the width W1 of the partition layer 11 in cross-sectional view increases toward the substrate 10. As shown in Fig. 1(b), the width between the inclined surfaces 111 of the pair of partition layers 11 is narrower on the substrate 10 side than on the cover layer 12 side. Therefore, the fluidic channel width W2 of the fluidic channel portion 13 decreases from the cover layer 12 side toward the substrate 10 side. More specifically, the fluidic channel width W2 is widest at the top of the fluidic channel portion 13 where the cover layer 12 is exposed, that is, between the upper ends 110a of the pair of partition layers 11. Further, the fluidic channel width W2 is narrowest at the bottom of the fluidic channel portion 13 where the substrate 10 is exposed, that is, between the lower ends 110b of the pair of partition layers 11.

As described above, since the inclined surface 111 provided on the entire side surface 110 of the partition layer 11 has a planar shape, the width W1 of the partition layer 11 continuously increases toward the substrate 10. That is, the width W1 increases in the transverse direction of the fluidic channel portion 13 as it approaches the substrate 10 such that each of the pair of opposing partition layers 11 approaches the other.

Therefore, the width between the inclined surfaces 111 of the pair of partition layers 11 becomes continuously narrower (decreases) toward the substrate 10. Accordingly, the fluidic channel width W2 of the fluidic channel portion 13 becomes continuously narrower (decreases) toward the substrate 10. More specifically, the fluidic channel width W2 continuously decreases from the top of the fluidic channel portion 13 where the cover layer 12 is exposed toward the bottom of the fluidic channel portion 13 where the substrate 10 is exposed.

The "continuously decreases" herein means that the fluidic channel width W2 of the fluidic channel portion 13 continuously decreases, without increasing, from the top of the fluidic channel portion 13 toward the bottom of the fluidic channel portion 13. Thus, as shown in Fig. 1(b), the fluidic channel portion 13 has an inverted trapezoidal shape in cross-sectional view. The "cross-section" in the "cross-sectional view" refers to a cross-section of the microfluidic chip 1 cut in the thickness direction (direction perpendicular to the longitudinal direction of the fluidic channel portion 13), and the cross-section includes the substrate 10, the partition layer 11, the cover layer 12 and the fluidic channel portion 13.

Since the width W2 of the fluidic channel portion 13 continuously decreases due to the width W1 of the partition layer 11 continuously increasing, the area of the bonding region for bonding the partition layer 11 and the substrate 10 can be reliably increased in the microfluidic chip 1, further reliably enhancing adhesion between the partition layer 11 and the substrate 10.

### (1.1.4.3) Bubble trapping region

In the microfluidic chip 1 according to the present embodiment, the fluidic channel portion 13 includes a bubble trapping region 130 that traps air bubbles in the fluidic channel portion 13. As shown in Fig. 1(b), the bubble trapping region 130 is formed by the inclined surface 111 of the partition layer 11 and the rear surface 12a which is the surface of the cover layer 12 on the fluidic channel portion 13 side.

Air bubbles may be present in the fluidic channel portion 13, for example, due to entrainment of air bubbles during injection of a fluid such as a reaction solution into the microfluidic chip 1, boiling due to heating of the reaction solution, air entrainment due to nonuniform flow in the microfluidic channel, foaming from the reaction solution itself, or the like.

As shown in Fig. 1(b), in the microfluidic chip 1, the fluidic channel width W2 of the fluidic channel portion 13 decreases toward the substrate 10. Therefore, if the above air bubbles drift in the fluidic channel portion 13, especially in a center region E1 of the fluidic channel portion 13, which is the region near the center, liquid flow may become unstable, or visibility of the liquid may be reduced when the interior of the fluidic channel portion 13 is observed through the cover layer 12 or the substrate 10.

In the microfluidic chip 1 according to the present embodiment, in which the bubble trapping region 130 is provided in the fluidic channel portion 13, air bubbles can be retained in a specific region (region other than the center region E1) in the fluidic channel portion 13. With this configuration, liquid flow can be stabilized and visibility during observation of the interior of the fluidic channel portion 13 can be improved.

As shown in Fig. 1(b), in the microfluidic chip 1 according to the present embodiment, the bubble trapping region 130 is a recess formed by the inclined surface 111 (side surface 110) of the partition layer 11 and the rear surface 12a of the cover layer 12, and the upper end 110a of the inclined surface 111 is the deepest portion. More specifically, the bubble trapping region 130 is a corner formed by the inclined surface 111 of the partition layer 11 and the rear surface 12a of the cover layer 12 connected to each other at the upper end of the inclined surface 111. That is, the bubble trapping region 130 is formed on each of the left and right sides on the top of the fluidic channel at which the fluidic channel width W2 of the fluidic channel portion 13 is widest. Therefore, by evacuating air bubbles into the bubble trapping region 130, the air bubbles can be retained in a region away from the center region E1 of the fluidic channel portion 13. With this configuration, the microfluidic chip 1 according to the present embodiment can further stabilize liquid flow and further improve the visibility during observation of the interior of the fluidic channel portion 13.

Air bubbles in the fluidic channel portion 13 migrate (upward) in the fluid (e.g., reaction solution) from the center region E1 toward the left and right sides of the fluidic channel portion 13 due to pressure or the like when the liquid flows, and are collected in the bubble trapping regions 130. In this example, the interior angle of the bubble trapping region 130 which is formed as a corner is an acute angle (less than 90 degrees). Accordingly, air bubbles collected in the bubble trapping region 130 are likely to remain in the bubble trapping region 130, and are less likely to leave toward the center region E1 of the channel portion 13.

As described above, the microfluidic chip 1 according to the present embodiment includes the substrate 10, the partition layer 11 made of a resin material, the partition layer 11 being disposed on the substrate 10 and defining the fluidic channel portion 13, and the cover layer 12 disposed on a side of the partition layer 11 opposite to that facing the substrate 10, the cover layer 10 covering the fluidic channel portion 13, wherein the partition layer 11 has a width which increases toward the substrate 10 in cross-sectional view. With this configuration, the microfluidic chip 1 can enhance adhesion between the wall (partition layer 11) and the substrate 10.

Further, in the microfluidic chip 1, the fluidic channel portion 13 includes the bubble trapping region 130 that traps air bubbles in the fluidic channel portion 13, and the bubble trapping region 130 is formed by the inclined surface 111 of the partition layer 11 and a surface (rear surface 12a) of the cover layer 12 on the fluidic channel portion 13 side. With this configuration, the microfluidic chip 1 can stabilize liquid flow and improves visibility during observation of the interior of the fluidic channel portion 13.

### (1.2) Method of producing microfluidic chip

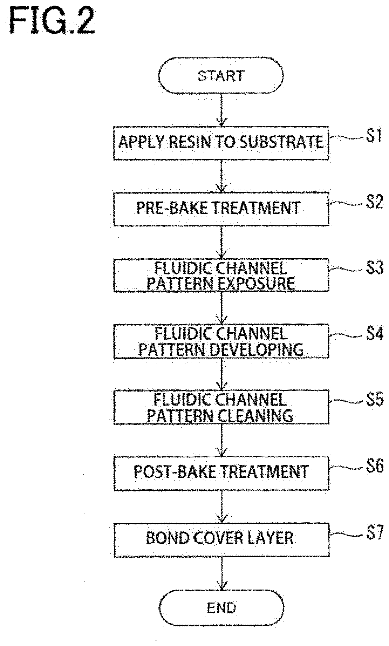

Next, a method of producing a microfluidic chip 1 according to the present embodiment will be described. Fig. 2 is a flowchart showing an example method of producing a microfluidic chip 1 according to the present embodiment.

The following description will be given of a case where the partition layer 11 is made of a photosensitive resin.

### (Step S1)

In a method of producing a microfluidic chip 1 according to the present embodiment, a step of applying a resin to the substrate 10 is first performed. Thus, a resin layer for forming the partition layer 11 is provided on the substrate 10. In a method of producing a microfluidic chip 1 according to the present embodiment, a resin layer (photosensitive resin layer) made of a photosensitive resin, for example, may be formed on the substrate 10.

The photosensitive resin layer may be formed on the substrate 10 by, for example, applying a photosensitive resin to the substrate 10. The application may be performed by, for example, spin coating, spray coating, bar coating, or the like, and in particular, spin coating is preferred from the perspective of controlling the film thickness. Various forms of photosensitive resin, such as liquid, gel and film, can be applied to the substrate 10. In particular, it is preferred to form a photosensitive resin layer using a liquid resist.

Further, the resin (for example, photosensitive resin) may be applied to the substrate 10 so that the thickness of the resin layer (for example, photosensitive resin layer), that is, thickness of the partition layer 11, becomes in the range of 5 µm or greater and 100 µm or less.

### (Step S2)

After the photosensitive resin is formed on the substrate 10, a step of heat treatment (pre-bake treatment) is performed to remove the solvent contained in the resin (for example, photosensitive resin) applied to the substrate 10. In the method of producing a microfluidic chip 1 according to the present embodiment, the pre-bake treatment is not an essential step, and may be appropriately performed at an optimal temperature and time according to the characteristics of the resin. For example, when the resin layer on the substrate 10 is a photosensitive resin, the pre-bake temperature and time are appropriately set to optimal conditions according to the characteristics of the photosensitive resin.

### (Step S3)

Next, a step of exposing the resin (for example, photosensitive resin) applied to the substrate 10 is performed. Specifically, exposure is performed to draw a fluidic channel pattern on the photosensitive resin applied to the substrate 10. Exposure may be performed with, for example, an exposure device using ultraviolet light as a light source or a laser drawing device. In particular, exposure with a proximity exposure device or a contact exposure device using ultraviolet light as a light source is preferred. When using a proximity exposure device, exposure is performed via a photomask having a fluidic channel pattern of the microfluidic chip 1. The photomask may be one having a light-shielding film with a bilayer structure of chromium and chromium oxide.

Further, as described above, the partition layer 11 is formed of a photosensitive resin that is photosensitive to light having a wavelength of 190 nm or greater and 400 nm or less, which is in the ultraviolet light region. Accordingly, in this step (exposure step), the photosensitive resin applied to the substrate 10 may be exposed to light having a wavelength of 190 nm or greater and 400 nm or less.

Further, when a chemically amplified resist or the like is used to form a resin layer on the substrate 10, heat treatment (post exposure bake: PEB) may be further performed after the exposure to promote catalytic reaction of the acid generated by exposure.

### (Step S4)

Next, a step of subjecting the exposed photosensitive resin to development is performed to form a fluidic channel pattern.

Development may be performed by reaction between the photosensitive resin and a developer using, for example, a spray, dip or puddle type development device. Examples of the developer include a sodium carbonate aqueous solution, tetramethylammonium hydroxide, potassium hydroxide and organic solvents. The developer is not limited to those described above, and a developing solution most suitable for the characteristics of the photosensitive resin may be appropriately used. Further, the concentration and development treatment time may be appropriately adjusted to optimal conditions according to the characteristics of the photosensitive resin.

### (Step S5)

Next, a step of cleaning is performed to completely remove the developer used for development from the resin layer (photosensitive resin layer) on the substrate 10. Cleaning may be performed using, for example, a spray, shower or immersion type cleaning device. Examples of the cleaning solution include pure water, isopropyl alcohol, and the like, and the cleaning solution most suitable for removing the developer used for the development treatment may be appropriately used. After cleaning, drying is performed using a spin dryer, IPA vapor dryer, or by natural drying, or the like.

### (Step S6)

Next, a step of heat treatment (post-bake) is performed on the partition layer 11 constituting the fluidic channel pattern, that is, the fluidic channel portion 13. This post-bake treatment removes residual water from development and cleaning. The post-bake treatment may be performed using, for example, a hot plate, oven, or the like. When drying in the cleaning step of step S5 is insufficient, the developer and water from cleaning may remain in the partition layer 11. Further, the solvent that has not been removed in the pre-bake treatment may also remain in the partition layer 11. These can be removed by the post-bake treatment.

### (Step S7)

Next, a step of bonding is performed to bond the cover layer 12 to the partition layer 11 after the post-bake treatment. In this step, as shown in Fig. 1(b), the cover layer 12 is bonded to a side of the partition layer 11 opposite to that facing the substrate 10. Thus, the fluidic channel portion 13 is covered with the cover layer 12, and the microfluidic chip 1 shown in Fig. 1(a) and Fig. 1(b) is formed.

The method of bonding the partition layer 11 and the cover layer 12 may be a method by thermocompression bonding after applying a surface modification treatment to the bonding surfaces of the partition layer 11 and the cover layer 12, a method using an adhesive, or a method of bonding by applying a surface modification treatment to the bonding surfaces of the partition layer 11 and the cover layer 12.

For example, in the method by thermocompression bonding described above, a surface modification treatment may be applied, after the post-bake treatment, to the partition layer 11 and the cover layer 12 (lid material) before being bonded to the partition layer 11. The surface modification treatment may be, for example, plasma treatment.

When the substrates subjected to surface modification treatment are bonded to each other by thermocompression bonding, thermocompression bonding using a heat press machine or a heat roll machine is preferred. It is preferred to form holes corresponding to the inlet 4 and the outlet 5 (see Fig. 1(a)) for a fluid in advance in the cover layer 12 before it is bonded to the partition layer 11. This can prevent problems of dust and contamination from occurring compared with the case where holes are formed in the cover layer 12 after it is bonded to the partition layer 11.

Further, when the partition layer 11 and the cover layer 12 are bonded using an adhesive, the adhesive can be determined according to affinity with the materials constituting the partition layer 11 and the cover layer 12. The adhesive is not specifically limited as long as it can bond the partition layer 11 and the cover layer 12 together. Examples of the adhesive according to the present embodiment include acrylic resin adhesives, urethane resin adhesives and epoxy resin adhesives.

Further, the method of bonding by surface modification treatment may be plasma treatment, corona discharge treatment, excimer laser treatment, or the like. In this case, while improving the reactivity of the surface of the partition layer 11, an optimal treatment method may be appropriately selected according to the affinity and adhesion between the partition layer 11 and the cover layer 12.

Thus, in the method of producing a microfluidic chip 1 according to the present embodiment, the partition layer 11 defining the fluidic channel portion 13 can be formed on the substrate 10 using photolithography.

For example, when the photosensitive resin applied to the substrate 10 is a positive resist, the photosensitive resin in the exposed region is dissolved during development and becomes the fluidic channel portion 13, and the photosensitive resin remaining in the unexposed region becomes the partition layer 11. Further, when the photosensitive resin applied to the substrate 10 is a negative resist, the photosensitive resin remaining in the exposed region becomes the partition layer 11, and the photosensitive resin in the unexposed region is dissolved during development and becomes the fluidic channel portion 13.

In the present embodiment, by removing excess resin (in this example, photosensitive resin) on the substrate 10 in the development step (step S4), the partition layer 11 can be formed to have a width which increases toward the substrate 10 in cross-sectional view.

In the present embodiment, the shape of the partition layer 11 can be controlled by adjusting, for example, the development time and the concentration of the developer in development. As an example, the longer the development time, the more resin in the upper part of the photosensitive resin layer for forming the partition layer 11, that is, the more resin on the side to which the cover layer 12 is bonded, can be dissolved. That is, in the partition layer 11 formed by removing excess resin by development, the closer to the substrate 10, the more resin remains, so that the width W1 of the partition layer 11 can be increased toward the substrate 10. Thus, by the development after the exposure step (step S3), the partition layer 11 having the width which increases toward the substrate 10 in cross-sectional view can be formed.

Further, the shape of the side surface 110 of the partition layer 11 can be formed in a desired shape by adjusting, for example, the development time and the concentration of the developer in development. For example, in the method of producing a microfluidic chip 1, the inclined surface 111 that is inclined relative to the substrate 10 can be formed on the side surface 110 of the partition layer 11 by development. More specifically, the inclined surface 111 in a planar shape can be formed on the entire side surface 110 of the partition layer 11 by development.

When the photosensitive resin layer is formed of a positive resist, the closer to the upper part of the photosensitive resin layer (the closer to the connection to the cover layer 12), the higher the amount of exposure, and the closer to the lower part (the closer to the substrate 10), the lower the amount of exposure. Accordingly, the closer to the upper part of the photosensitive resin layer, the more resin is dissolved and removed during development, and the closer to lower part, the more resin remains without being dissolved during development. Therefore, the photosensitive resin that remains on the substrate 10 to form the partition layer 11 increases toward the substrate 10. Thus, by using a positive resist, the partition layer 11 having the width which increases toward the substrate 10 in cross-sectional view can be more easily formed.

As described above, the method of producing a microfluidic chip 1 according to the present embodiment includes the steps of: applying a resin to a substrate 10 (the above step S1); exposing the applied resin to light (the above step S3); subjecting the exposed resin to development and cleaning to thereby form a partition layer 11 that defines a fluidic channel portion 13 on the substrate 10 (the above steps 4 and S5); post-baking the partition layer 11 (the above step S6); and bonding a cover layer 12 to a side of the partition layer 11 opposite to that facing the substrate 10 (the above step S7). Further, by removing excess resin (in this example, photosensitive resin) on the substrate 10 in the development step (step S4), the partition layer 11 is formed to have a width which increases toward the substrate 10 in cross-sectional view.

Thus, a microfluidic chip with enhanced adhesion between the wall (partition layer 11) and the substrate 10 can be obtained.

### (1.3) Modified examples

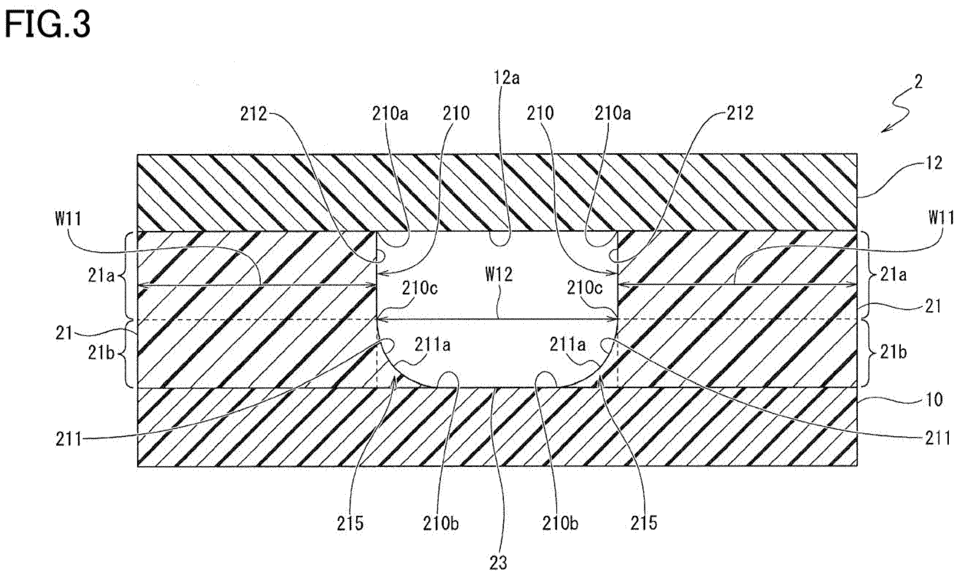

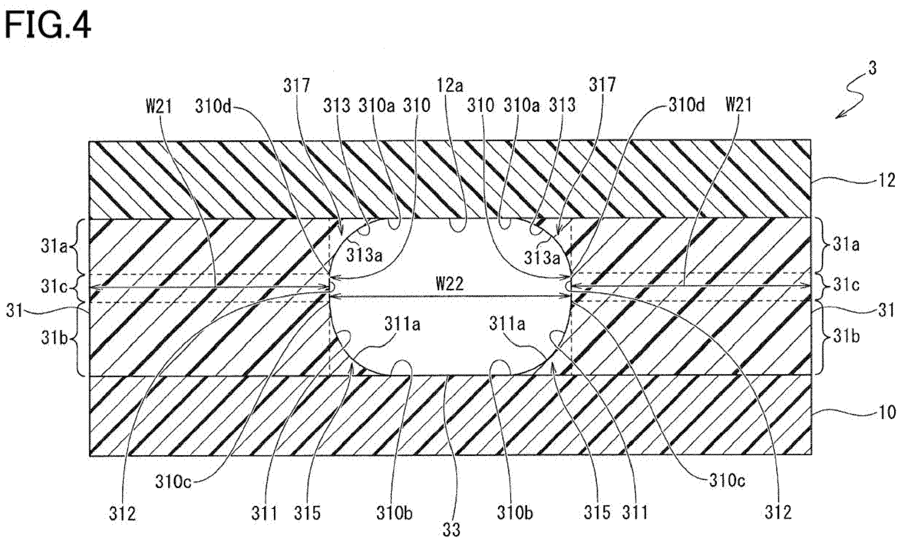

With reference to Figs. 3 and 4, a microfluidic chip according to a modified example of the present embodiment will be described. First, referring to Fig. 3, a configuration of a microfluidic chip 2 according to a first modified example of the present embodiment will be described.

### (1.3.1) First modified example

Fig. 3 is a cross-sectional diagram illustrating an example configuration of the microfluidic chip 2 according to the first modified example of the present embodiment.

The microfluidic chip 2 includes a substrate 10, a partition layer 21 that defines a fluidic channel portion 23 on the substrate 10, and a cover layer 12. As shown in Fig. 3, the microfluidic chip 2 differs from the microfluidic chip 1 described in the above embodiment in that an inclined surface 211 is provided on a part of the side surface 210 of the partition layer 21.

The following description will be given of the partition layer 21 and the fluidic channel portion 23 defined by the partition layer 21. Components other than the partition layer 21 and the fluidic channel portion 23 (substrate 10 and cover layer 12) have the same configuration as the substrate 10 and the cover layer 12 of the microfluidic chip 1, and the description thereof will be omitted.

### (1.3.1.1) Shape of partition layer and configuration of fluidic channel

In the following description, details of the shape of the partition layer 21 and the configuration of the fluidic channel portion 23 in the microfluidic chip 2 according to this modified example will be described. First, the shape of the partition layer 21 that defines the fluidic channel portion 23 will be described.

As shown in Fig. 3, a width W11 of the partition layer 21 of the microfluidic chip 2 increases toward the substrate 10 in cross-sectional view. The "cross-section" in the "cross-sectional view" refers to a cross-section of the microfluidic chip 2 cut in the thickness direction (direction perpendicular to the longitudinal direction of the fluidic channel portion 23), for example, and the cross-section includes at least the substrate 10, the partition layer 21 and the fluidic channel portion 23.

In the microfluidic chip 2, as with the microfluidic chip 1 according to the first embodiment, the width W11 of the partition layer 21 increases toward the substrate 10, whereby the area of the bonding region for bonding a wall (in this example, partition layer 21) and the substrate 10 can be increased, enhancing adhesion between the wall and the substrate 10. This can prevent occurrence of liquid leakage, damage, and the like during use of the microfluidic chip 2. In the following description, the shape of the partition layer 21 will be more specifically described.

In this modified example, the partition layer 21 of the microfluidic chip 2 includes a side surface 210 that defines the fluidic channel portion 23. The side surface 210 is connected to the cover layer 12 at an upper end 210a which is an end on the cover layer 12 side, and connected to the substrate 10 at a lower end 210b which is an end of the side surface 210 on the substrate 10 side.

As shown in Fig. 3, the inclined surface 211 is provided on one end side of the side surface 210. Specifically, the inclined surface 211 is provided on a lower end 210b side of the side surface 210.

On the other hand, no inclined surface is provided on the other end (upper end 210a) side of the side surface 210. That is, in the side surface 210, the inclined surface 211 does not include the upper end 210a. In the side surface 210, a flat surface 212 is provided in a region where the inclined surface 211 is not provided.

The flat surface 212 is connected to the cover layer 12 at the upper end 210a, and connected to the inclined surface 211 at an intermediate end 210c formed between the upper end 210a and the lower end 210b.

That is, the upper end 210a of the side surface 210 corresponds to the upper end of the flat surface 212, and the intermediate end 210c corresponds to the lower end of the flat surface 212. Further, the intermediate end 210c of the side surface 210 corresponds to the upper end of the inclined surface 211, and the lower end 210b of the side surface 210 corresponds to the lower end of the inclined surface 211.

Hereinafter, a region of the partition layer 21 including the flat surface 212 is referred to as an upper region 21a, and a region including the inclined surface 211 is referred to as a lower region 21b. In Fig. 3, the upper region 21a and the lower region 21b of the partition layer 21 are divided by a virtual dotted line for ease of understanding. In the partition layer 21, the upper region 21a and the lower region 21b are preferably formed integrally, but may be formed separately. That is, the partition layer 21 may have a multilayer (e.g., two-layer) structure.

The width W11 of the partition layer 21 is constant throughout the upper region 21a which includes the flat surface 212, and increases toward the substrate 10 in the lower region 21b which includes the inclined surface 211. With this configuration, the area of the bonding region for bonding the partition layer 21 and the substrate 10 can be increased, while maintaining the width (fluidic channel width W12) of the fluidic channel defined by the partition layer 21 in the microfluidic chip 2.

Next, the inclined surface 211 provided on the side surface 210 of the partition layer 21 will be specifically described.

In the partition layer 21 of the microfluidic chip 2 according to this modified example, the inclined surface 211 is formed on a part of the side surface 210 and curved in a concave shape in cross-sectional view.

As described above, in the partition layer 21, the inclined surface 211 includes the lower end 210b which is one end of the side surface 210, and is connected to the substrate 10 at the lower end 210b. That is, the lower end 210b is also one end (lower end) of the inclined surface 211. In other words, in the partition layer 21, one end (lower end 210b) of the inclined surface 211 is in contact with the substrate 10.

More specifically, the inclined surface 211 extends from the intermediate end 210c, which corresponds to an end of the flat surface 212 of the side surface 210 on a side opposite to that in contact with the cover layer 12, to the lower end 210b, and the inclined surface 211 is connected to the flat surface 212 of the side surface 210 at the intermediate end 210c, and connected to the substrate 10 at the lower end 210b.

The inclined surface 211 is provided on the side surface 210 of the lower region 21b of the partition layer 21, that is, on a region of the side surface 210 on the substrate 10 side.

As shown in Fig. 3, in the lower region 21b of the partition layer 21, the lower end 210b of the side surface 210 (lower end of the inclined surface 211) is located closer to the center of the fluidic channel portion 23 than the intermediate end 210c (upper end of the inclined surface 211) is. That is, the lower end 210b of the side surface 210 (lower end of the inclined surface 211) is located closer to the opposing partition layer 21 than the upper end 210a is. In other words, in the partition layer 21, the intermediate end 210c of the side surface 210 (upper end of the inclined surface 211) is located further away from the center of the fluidic channel portion 23 than the lower end 210b (lower end of the inclined surface 211) is. That is, the intermediate end 210c of the side surface 210 (upper end of the inclined surface 211) is located further away from the opposing partition layer 21 than the lower end 210b is.

The inclined surface 211 extends downward in an inclined manner from the intermediate end 210c connected to the flat surface 212 which includes the upper end 210a to the lower end 210b, where it is connected to the substrate 10. Thus, the width W11 of the partition layer 21 in cross-sectional view increases in the direction toward the center of the fluidic channel portion 23, that is, toward the opposing partition layer 21 (in the transverse direction of the fluidic channel portion 23), as it approaches the substrate 10. Therefore, the width W11 of the partition layer 21 in cross-sectional view increases toward the substrate 10.

The width W11 of the partition layer 21 continuously increases toward the substrate 10. More specifically, the width W11 of the lower region 21b of the partition layer 21 continuously expands and increases toward the center of the fluidic channel portion 23, that is, in the transverse direction, as it approaches the substrate 10.

The "continuously increases (expands)" herein means that the width W11 of the partition layer 21 continuously increases (expands), without decreasing (reducing), from the intermediate end 210c where the inclined surface 211 is connected to the flat surface 212 to the lower end 210b where the inclined surface 211 is connected to the substrate 10.

As shown in Fig. 3, in the inclined surface 211 curved in a concave shape, a deepest portion 211a is located closer to the center of the fluidic channel portion 23 than the intermediate end 210c which is the upper end of the inclined surface 211 (lower end of the flat surface 212) is. Therefore, the width W11 of the partition layer 21 continuously increases, without decreasing, even in the deepest portion 211a of the inclined surface 211. With this configuration, in the microfluidic chip 2, the area of the bonding region for bonding the partition layer 21 and the substrate 10 can be reliably increased, further reliably enhancing adhesion between the partition layer 21 and the substrate 10.

Further, as shown in Fig. 3, the partition layer 21 includes an extension portion 215 which includes the curved inclined surface 211 and extends in the transverse direction of the fluidic channel portion 23 along the surface of the substrate 10. In other words, the extension portion 215 extends in the direction toward the center of the fluidic channel portion 23, that is, toward the opposing partition layer 21. Further, the extension portion 215 has a shape in which the thickness decreases in the transverse direction of the fluidic channel portion 23. That is, the extension portion 215 has a flared shape. With this configuration, compared with the case where the inclined surface 211 has a planar shape, the microfluidic chip 2 can reduce a decrease in the width (fluidic channel width W12) of the fluidic channel portion 23 due to an increase in the width W11 of the partition layer 21, while increasing the area of the bonding region for bonding the partition layer 21 and the substrate 10.

Next, the configuration of the fluidic channel portion 23 defined by the substrate 10, the partition layer 21 and the cover layer 12 will be described. The fluidic channel portion 23 has a fluidic channel width W12 defined as the width between a pair of partition layers 21 facing each other, that is, the width between the side surfaces 210.

As described above, the width W11 of the partition layer 21 in cross-sectional view increases toward the substrate 10. As shown in Fig. 3, the width between the side surfaces 210 of the pair of partition layers 21 is narrower on the substrate 10 side than on the cover layer 12 side. Therefore, the fluidic channel width W12 of the fluidic channel portion 23 decreases from the cover layer 12 side toward the substrate 10 side.

Specifically, the fluidic channel width W12 is widest at the top region of the fluidic channel portion 23 where the cover layer 12 is exposed, that is, between the upper ends 210a of the pair of partition layers 21. As described above, the width W11 of the partition layer 21 is constant in the upper region 21a which includes the flat surface 212 extending from the upper end 210a to the intermediate end 210c of the side surface 210. Accordingly, the fluidic channel width W12 between the upper regions 21a of the pair of partition layers 21, that is, the fluidic channel width W12 between the flat surfaces 212 of the pair of partition layers 21, is constant. That is, the fluidic channel width W12 of the fluidic channel portion 23 is widest in the region between the flat surfaces 212.

Further, the fluidic channel width W12 is narrowest at the bottom of the fluidic channel portion 23 where the substrate 10 is exposed, that is, between the lower ends 210b of the pair of partition layers 21.

As described above, the width W11 of the partition layer 21 continuously increases toward the substrate 10 in the lower region 21b which includes the inclined surface 211 extending from the intermediate end 210c to the lower end 210b of the side surface 210. Specifically, in the pair of partition layers 21 facing each other, each of the extension portions 215, which include the inclined surface 211, approaches the other in the transverse direction of the fluidic channel portion 23. Therefore, the width between the inclined surfaces 211 of the pair of partition layers 21 becomes continuously narrower (decreases) toward the substrate 10. That is, the width between the inclined surfaces 211 of the pair of partition layers 21 becomes continuously narrower (decreases) toward the substrate 10.

The "continuously decreases" herein means that the fluidic channel width W12 of the fluidic channel portion 23 continuously decreases, without increasing, from the intermediate portion of the fluidic channel portion 23 (between the intermediate ends 210c of the pair of partition layers 21) toward the bottom of the fluidic channel portion 23 (between the lower ends 210b of the pair of partition layers 21).

Thus, the width of the fluidic channel portion 23 continuously decreases toward the substrate 10 in a region formed by the curved inclined surface 211 of the side surface 210 of the partition layer 21, and is constant in a region formed by a surface of the side surface 210 other than the inclined surface 211, that is, formed by the flat surface 212. With this configuration, a region with the reduced fluidic channel width W12 can be limited to a region on the bottom side (substrate 10 side) of the fluidic channel portion 23, that is, between the inclined surfaces 211. Accordingly, in the microfluidic chip 2, the area of the bonding region for bonding the partition layer 21 and the substrate 10 can be reliably increased, while maintaining the width of the fluidic channel width W12 of the fluidic channel portion 23 in a region between the flat surfaces 212 of the pair of partition layers 21. Therefore, the microfluidic chip 2 can reliably enhance adhesion between the partition layer 21 and the substrate 10, while improving flow stability of a fluid (e.g., reaction solution) in the fluidic channel portion 23 and visibility during observation of the interior of the fluidic channel portion 23.

Further, as shown in Fig. 3, the fluidic channel portion 23 has a rounded corner shape in cross-sectional view in a region between the lower regions 21b of the pair of partition layers 21, that is, a region between the curved inclined surfaces 211. The "cross-section" in the "cross-sectional view" refers to a cross-section of the microfluidic chip 1 cut in the thickness direction (direction perpendicular to the longitudinal direction of the fluidic channel portion 23), and the cross-section includes the substrate 10, the partition layer 21, the cover layer 12 and the fluidic channel portion 23. Since the fluidic channel portion 23 has a rounded corner shape in cross-sectional view in a region between the inclined surfaces 211, a liquid flow speed and a flow rate of a fluid (e.g., reaction solution) in the fluidic channel portion 23 can be stabilized.

The shape of the partition layer 21 and the configuration of the fluidic channel portion 23 in the microfluidic chip 2 according to this modified example has been described. The basic configuration such as materials other than the shape of the partition layer 21, the thickness (fluidic channel height), and the width and fluidic channel length of the fluidic channel portion 23 are the same as those of the partition layer 11 and the fluidic channel portion 13 of the microfluidic chip 1 according to the first embodiment, and the description thereof will be omitted.

### (1.3.1.2) Method of producing microfluidic chip

The basic method of producing a microfluidic chip 2 according to this modified example is the same as the method of producing a microfluidic chip 1 according to the first embodiment described above (see Fig. 2), and detailed description will be omitted.

Also in this modified example, by removing excess resin (in this example, photosensitive resin) on the substrate 10 in the development step (step S4), the partition layer 21 can be formed to have a width which increases toward the substrate 10 in cross-sectional view.

In this modified example, the inclined surface 211 may be formed on a part of the partition layer 21 by adjusting the development time, the concentration of the developer, and the like in development.

For example, in this modified example, development may be performed to dissolve and remove a constant amount of resin in a partial region from the upper side of the photosensitive resin layer (side connected to the cover layer 12), so that a constant amount of resin remains. Accordingly, the width W11 of the partition layer 21 in the upper region 21a of the partition layer 21 can be constant. Further, in the remaining region of the photosensitive resin layer (region on the substrate 10 side), the degree of resin dissolution may be reduced to reduce the amount of resin to be removed as it closer to the substrate 10 so that the more resin remains as it closer to the substrate 10. Accordingly, the width W11 of the partition layer 21 in the lower region 21b of the partition layer 21 can be increased toward the substrate 10.

For example, by removing excess resin by development, the inclined surface 211 can be formed in the lower region 21b of the partition layer 21. Further, the inclined surface 211 can be formed in a curved shape in cross-sectional view by adjusting, for example, the development time and the concentration of the developer in development. Therefore, the inclined surface 211 curved in a concave shape in cross-sectional view with one end (lower end 210b) being in contact with the substrate 10 can be formed by development on the side surface 210 (a part of the side surface 210) of the lower region 21b of the partition layer 21. Thus, a microfluidic chip 3 can be obtained in which the area of the bonding region for bonding the partition layer 21 and the substrate 10 can be increased, enhancing adhesion between the partition layer 21 and the substrate 10.

Further, the flat surface 212 can be formed by development on the side surface 210 of the upper region 21a of the partition layer 21.

Also in this modified example, by using a positive resist to form the photosensitive resin layer, the partition layer 21 having the width which increases toward the substrate 10 in cross-sectional view can be more easily formed. Further, the flat surface 211 in a curved shape can be easily formed on the side surface 210 of the lower region 21b of the partition layer 21.

### (1.3.2) Second modified example

Fig. 4 is a cross-sectional diagram illustrating an example configuration of a microfluidic chip 3 according to the second modified example of the present embodiment.

The microfluidic chip 3 includes a substrate 10, a partition layer 31 that defines a fluidic channel portion 33 on the substrate 10, and a cover layer 12. As shown in Fig. 3, the microfluidic chip 3 differs from the microfluidic chip 2 according to the first modified example described above in that a plurality of inclined surfaces (inclined surfaces 311 and 313 described later) are provided on a side surface 310 of the partition layer 31.

The following description will be given of the partition layer 31 and the fluidic channel portion 33 defined by the partition layer 31. Components other than the partition layer 31 and the fluidic channel portion 33 (substrate 10 and cover layer 12) have the same configuration as the substrate 10 and the cover layer 12 of the microfluidic chip 1, and the description thereof will be omitted.

### (1.3.2.1) Shape of partition layer and configuration of fluidic channel

In the following description, details of the shape of the partition layer 21 and the configuration of the fluidic channel portion 23 in the microfluidic chip 2 according to this modified example will be described. First, the shape of the partition layer 31 that defines the fluidic channel portion 33 will be described. As shown in Fig. 4, the partition layer 31 of the microfluidic chip 3 has a shape in which a width W21 increases toward both the substrate 10 and the cover layer 12 in cross-sectional view.

With this configuration, in the microfluidic chip 3, the areas of the bonding region for bonding the partition layer 31 and the substrate 10 and the bonding region for bonding the partition layer 31 and the cover layer 12 increase. Accordingly, in addition to the adhesion between the partition layer 31 and the substrate 10, the adhesion between the partition layer 31 and the cover layer 12 can be enhanced. This can reliably prevent occurrence of liquid leakage, damage, and the like during use of the microfluidic chip 3.

The "cross-section" in the "cross-sectional view" refers to a cross-section of the microfluidic chip 3 cut in the thickness direction (direction perpendicular to the longitudinal direction of the fluidic channel portion 33), for example, and the cross-section includes the substrate 10, the partition layer 31, the cover layer 12 and the fluidic channel portion 33. In the following description, the shape of the partition layer 31 will be more specifically described.

The partition layer 31 of the microfluidic chip 3 includes a side surface 310 that defines the fluidic channel portion 33. The side surface 310 is connected to the cover layer 12 at an upper end 310a which is an end on the cover layer 12 side. Further, the side surface 310 is connected to the substrate 10 at a lower end 310b which is an end on the substrate 10 side. As shown in Fig. 4, the side surface 310 has an inclined surface 311 that is inclined relative to the substrate 10 and an inclined surface 313 that is inclined relative to the cover layer 12. The partition layer 31 of the microfluidic chip 3 differs from the partition layer 21 of the microfluidic chip 2 according to the first modified example in that the side surface 310 of the partition layer 31 has the inclined surface 311 and the inclined surface 313 at respective ends.

As shown in Fig. 4, the inclined surface 311 is provided on one end side of the side surface 310. Specifically, the inclined surface 311 is provided on a lower end 310b side of the side surface 310.

On the other hand, the inclined surface 313 is provided on the other end side of the side surface 310. Specifically, the inclined surface 313 is provided on an upper end 310a side of the side surface 310. Further, a flat surface 312 is formed in a region of the side surface 310 in which the inclined surfaces (inclined surfaces 311 and 313) are not provided, that is, a region between the inclined surface 311 and the inclined surface 313.

The flat surface 312 is connected to the inclined surface 311 at a first intermediate end 310c, and connected to the inclined surface 313 at a second intermediate end 311d. That is, the flat surface 312 extends from the first intermediate end 311c to the second intermediate end 310d of the side surface 310, with the first intermediate end 311c corresponding to the lower end of the flat surface 312 and the second intermediate end 310d corresponding to the upper end of the flat surface 312.

Further, the inclined surface 311 is connected to the substrate 10 at the lower end 310b of the side surface 310, and connected to the flat surface 312 at the first intermediate end 310c of the side surface 310. That is, the inclined surface 311 extends from the lower end 310b to the first intermediate end 311c of the side surface 310, with the lower end 310b of the side surface 310 corresponding to the lower end of the inclined surface 311 and the first intermediate end 311c of the side surface 310 corresponding to the upper end of the inclined surface 311.

Further, the inclined surface 313 is connected to the flat surface 312 at the second intermediate end 310d of the side surface 310, and connected to the cover layer 12 at the upper end 310a of the side surface 310. That is, the inclined surface 313 extends from the second intermediate end 310d to the upper end 310a of the side surface 310, with the second intermediate end 310d of the side surface 310 corresponding to the lower end of the inclined surface 313 and the upper end 310a of the side surface 310 corresponding to the upper end of the inclined surface 311.

Hereinafter, a region of the partition layer 31 including the inclined surface 313 is referred to as an upper region 31a, a region including the inclined surface 311 is referred to as a lower region 31b, and a region including the flat surface 312 is referred to as an intermediate region 31c. In Fig. 4, the upper region 31a, the lower region 31b and the intermediate region 31c of the partition layer 31 are divided by a virtual dotted line for ease of understanding. In the partition layer 31, the upper region 31a, the lower region 31b and the intermediate region 31c are preferably formed integrally, but may be formed separately. That is, the partition layer 21 may have a multilayer (e.g., three-layer) structure.

The width W21 of the partition layer 31 increases toward the substrate 10 in the lower region 31b which includes the inclined surface 311, increases toward the cover layer 12 in the upper region 31a which includes the inclined surface 313, and is constant in the intermediate region 31c which includes the flat surface 312. With this configuration, the areas of the bonding region for bonding the partition layer 31 and the substrate 10 and the bonding region for bonding the partition layer 31 and the cover layer 12 can be increased, while maintaining the width (fluidic channel width W22) of the fluidic channel defined by the partition layer 31 in the microfluidic chip 3.

Next, the inclined surface 311 provided on the side surface 310 of the partition layer 31 will be specifically described.

In the partition layer 31 of the microfluidic chip 3 according to this modified example, the inclined surface 311 is formed on a part of the side surface 310 (side surface 310 of the lower region 31b of the partition layer 31) and curved in a concave shape in cross-sectional view. The inclined surface 311 provided on the side surface 310 of the partition layer 31 has the same configuration as the inclined surface 211 provided on the side surface 210 of the partition layer 21 in the microfluidic chip 2 according to the first modified example, but the partition layer 21 and the partition layer 31 are different in configuration, so the inclined surface 311 will be described below.

The curved inclined surface 311 is provided on the side surface 310 of the lower region 31b of the partition layer 31, that is, on a region of the side surface 310 on the substrate 10 side.

As shown in Fig. 4, in the lower region 31b of the partition layer 31, the lower end 310b of the side surface 310 (lower end of the inclined surface 311) is located closer to the center of the fluidic channel portion 33 than the first intermediate end 310c (upper end of the inclined surface 311) is. That is, the lower end 310b of the side surface 310 (lower end of the inclined surface 311) is located closer to the opposing partition layer 31 than the first intermediate end 310c is.

In other words, in the partition layer 31, the first intermediate end 310c of the side surface 310 (upper end of the inclined surface 311) is located further away from the center of the fluidic channel portion 33 than the lower end 310b (lower end of the inclined surface 311) is. That is, the first intermediate end 310c of the side surface 310 (upper end of the inclined surface 311) is located further away from the opposing partition layer 31 than the lower end 310b is.

The inclined surface 311 extends downward in an inclined manner from the first intermediate end 310c connected to the flat surface 312 to the lower end 310b, where it is connected to the substrate 10. Thus, the width W21 of the partition layer 31 increases in the direction toward the center of the fluidic channel portion 33, that is, toward the opposing partition layer 31 (in the transverse direction of the fluidic channel portion 33), as it approaches the substrate 10. Therefore, the width W21 of the partition layer 31 in cross-sectional view increases toward the substrate 10.

The width W21 of the lower region 21b of the partition layer 31 continuously increases toward the substrate 10. More specifically, the width W21 of the lower region 31b continuously expands and increases toward the center of the fluidic channel portion 33, that is, in the transverse direction, as it approaches the substrate 10.

The "continuously increases (expands)" herein means that the width W21 of the partition layer 31 continuously increases (expands), without decreasing (reducing), from the first intermediate end 310c where the inclined surface 311 is connected to the flat surface 312 to the lower end 310b where the inclined surface 311 is connected to the substrate 10.

As shown in Fig. 4, in the inclined surface 311 curved in a concave shape, a deepest portion 311a is located closer to the center of the fluidic channel portion 33 than the first intermediate end 310c which is the upper end of the inclined surface 311 (lower end of the flat surface 312) is. Therefore, the width W21 of the partition layer 31 continuously increases, without decreasing, even in the deepest portion 311a of the inclined surface 311. With this configuration, in the microfluidic chip 3, the area of the bonding region for bonding the partition layer 31 and the substrate 10 can be reliably increased, further reliably enhancing adhesion between the partition layer 31 and the substrate 10.

Further, as shown in Fig. 4, the partition layer 31 includes an extension portion 315 which includes the curved inclined surface 311 in the lower region 31b and extends in the transverse direction of the fluidic channel portion 33 along the surface of the substrate 10. In other words, the extension portion 315 extends in the direction toward the center of the fluidic channel portion 33, that is, toward the opposing partition layer 31. Further, the extension portion 315 has a shape in which the thickness decreases in the transverse direction of the fluidic channel portion 33. That is, the extension portion 315 has a flared shape. With this configuration, compared with the case where the inclined surface 311 has a planar shape, the microfluidic chip 3 can reduce a decrease in the width (fluidic channel width W22) of the fluidic channel portion 33 due to an increase in the width W21 of the partition layer 31, while increasing the area of the bonding region for bonding the partition layer 31 and the substrate 10.

Next, the inclined surface 311 provided on the side surface 310 of the partition layer 31 will be described. In the partition layer 31 of the microfluidic chip 3 according to this modified example, the inclined surface 313 is formed on a part of the remaining side surface 310 (side surface 310 of the upper region 31a of the partition layer 31) and curved in a concave shape in cross-sectional view.

The curved inclined surface 313 is provided on the side surface 310 of the upper region 31a of the partition layer 31, that is, on a region of the side surface 310 on the cover layer 12 side.

As shown in Fig. 4, in the upper region 31a of the partition layer 21, the upper end 310a of the side surface 310 (upper end of the inclined surface 313) is located closer to the center of the fluidic channel portion 33 than the second intermediate end 310d (lower end of the inclined surface 313) is. That is, the upper end 310a of the side surface 310 (upper end of the inclined surface 313) is located closer to the opposing partition layer 31 than the second intermediate end 310d is.

In other words, in the partition layer 31, the second intermediate end 310d of the side surface 310 (lower end of the inclined surface 313) is located further away from the center of the fluidic channel portion 33 than the upper end 310a (upper end of the inclined surface 313) is. That is, the second intermediate end 310d of the side surface 310 (lower end of the inclined surface 313) is located further away from the opposing partition layer 31 than the upper end 310a is.

The inclined surface 311 extends upward in an inclined manner from the second intermediate end 310d connected to the flat surface 312 to the upper end 310a, where it is connected to the cover layer 12. Thus, the width W21 of the partition layer 31 increases in the direction toward the center of the fluidic channel portion 33, that is, toward the opposing partition layer 31 (in the transverse direction of the fluidic channel portion 33), as it approaches the cover layer 12. Therefore, the width W21 of the partition layer 31 in cross-sectional view increases toward the cover layer 12.

The width W21 of the upper region 31a of the partition layer 31 continuously increases toward the cover layer 12. More specifically, the width W21 of the upper region 31a of the partition layer 31 continuously expands and increases toward the center of the fluidic channel portion 33, that is, in the transverse direction, as it approaches the cover layer 12.

The "continuously increases (expands)" herein means that the width W21 of the partition layer 31 continuously increases (expands), without decreasing (reducing), from the second intermediate end 310d where the inclined surface 313 is connected to the flat surface 312 to the lower end 310b where the inclined surface 311 is connected to the cover layer 12.

As shown in Fig. 4, in the inclined surface 313 curved in a concave shape, a deepest portion 313a is located closer to the center of the fluidic channel portion 33 than the second intermediate end 310d which is the lower end of the inclined surface 313 (upper end of the flat surface 312) is. Therefore, the width W21 of the partition layer 31 continuously increases, without decreasing, even in the deepest portion 313a of the inclined surface 313. With this configuration, in the microfluidic chip 3, the area of the bonding region for bonding the partition layer 31 and the cover layer 12 can be reliably increased, further reliably enhancing adhesion between the partition layer 31 and the cover layer 12.

Further, as shown in Fig. 4, the partition layer 31 includes an extension portion 317 which includes the curved inclined surface 313 in the upper region 31a and extends in the transverse direction of the fluidic channel portion 33 along the rear surface 12a of the cover layer 12. In other words, the extension portion 317 extends in the direction toward the center of the fluidic channel portion 33, that is, toward the opposing partition layer 31. Further, the extension portion 317 has a shape in which the thickness decreases in the transverse direction of the fluidic channel portion 33. That is, the extension portion 317 has a flared shape. With this configuration, compared with the case where the inclined surface 313 has a planar shape, the microfluidic chip 3 can reduce a decrease in the width (fluidic channel width W22) of the fluidic channel portion 33 due to an increase in the width W21 of the partition layer 31, while increasing the area of the bonding region for bonding the partition layer 31 and the cover layer 12.

As described above, in the microfluidic chip 3 according to this modified example, the partition layer 31 includes the inclined surface 311 (an example of the first inclined surface) which is a curved inclined surface provided on a part of the side surface 310 and the inclined surface (an example of the second inclined surface) 313 which is provided on the remaining portion (portion in which the inclined surface 311 is not provided) of the side surface 310. The inclined surface 313 is curved in a concave shape in cross-sectional view, and one end of the inclined surface 313 is connected to the cover layer 12. Further, the flat surface 312 is provided on the side surface 310 between the inclined surface 311 and the inclined surface 313.

That is, the partition layer 31 has flared-shape portions respectively on the substrate 10 side and the cover layer 12 side. Accordingly, the partition layer 31 has a shape in which the width W21 increases toward both the substrate 10 and the cover layer 12 With this configuration, in the microfluidic chip 3, the bonding region for bonding the partition layer 31 and the substrate 10 and the bonding region for bonding the partition layer 31 and the cover layer 12 increase. Therefore, the microfluidic chip 3 can enhance adhesion between the partition layer 31 and the substrate 10 and adhesion between the partition layer 31 and the cover layer 12, and can reliably prevent occurrence of liquid leakage, damage, and the like during use of the microfluidic chip 3.

In the partition layer 31, the inclined surface 311 and the inclined surface 313 may have the same shape or different shapes. For example, the inclined surface 311 may be curved more deeply than the inclined surface 313 is, or the inclined surface 313 may be curved more deeply than the inclined surface 311 is. For example, the deepest portion 311a of the inclined surface 311 may be located further away from the center of the fluidic channel portion 33 than the deepest portion 313a of the inclined surface 313 is, or the deepest portion 313a of the inclined surface 313 may be located further away from the center of the fluidic channel portion 33 than the deepest portion 311a of the inclined surface 311 is.

Next, the configuration of the fluidic channel portion 33 defined by the substrate 10, the partition layer 31 and the cover layer 12 will be described. The fluidic channel portion 33 has a fluidic channel width W22 defined as the width between a pair of partition layers 31 facing each other, that is, the width between the side surfaces 310.

As described above, the width W21 of the partition layer 31 in cross-sectional view increases toward each of the substrate 10 and the cover layer 12. As shown in Fig. 4, the width between the side surfaces 310 of the pair of partition layers 21 is narrower on the substrate 10 side and the cover layer 12 side than between the flat surfaces 312. Therefore, the fluidic channel width W22 of the fluidic channel portion 33 decreases from the center region in the height of the fluidic channel portion 33 (thickness of the partition layer 31) toward each of the substrate 10 and the cover layer 12.

Specifically, the fluidic channel width W22 is widest between the flat surfaces 312 of the side surfaces 310 of the pair of partition layers 31. As described above, the width W21 of the partition layer 31 is constant in the intermediate region 31c which includes the flat surface 312 extending from the first intermediate end 310c to the second intermediate end 310d of the side surface 310. Accordingly, the fluidic channel width W22 between the intermediate regions 31c of the pair of partition layers 31, that is, the fluidic channel width W22 between the flat surfaces 312 of the pair of partition layers 31, is constant. That is, the fluidic channel width W22 of the fluidic channel portion 33 is widest in the region between the flat surfaces 312.

Further, the fluidic channel width W22 is narrowest at the bottom of the fluidic channel portion 33 where the substrate 10 is exposed, that is, between the lower ends 310b of the pair of partition layers 31 and at the top of the fluidic channel portion 33 where the rear surface 12a of the cover layer 12 is exposed, that is, between the upper ends 310a of the pair of partition layers 31.

As described above, the width W21 of the partition layer 31 continuously increases toward the substrate 10 in the lower region 31b which includes the inclined surface 311 extending from the first intermediate end 310c to the lower end 310b of the side surface 310. That is, in the pair of partition layers 31 facing each other, each of the extension portions 315, which include the inclined surface 311, approaches the other in the transverse direction of the fluidic channel portion 33. Therefore, the width between the inclined surfaces 311 of the pair of partition layers 31 becomes continuously narrower (decreases) toward the substrate 10. That is, the width between the inclined surfaces 311 of the pair of partition layers 31 becomes continuously narrower (decreases) toward the substrate 10.

The "continuously decreases" herein means that the fluidic channel width W22 of the fluidic channel portion 33 continuously decreases, without increasing, from a region between the lower ends of the flat surfaces 312 (region between the first intermediate ends 310c of the pair of partition layers 31) toward the bottom of the fluidic channel portion 33 (between the lower ends 310b of the pair of partition layers 31).

Further, as described above, the width W21 of the partition layer 31 continuously increases toward the cover layer 12 in the upper region 31a which includes the inclined surface 313 extending from the second intermediate end 310d to the upper end 310a of the side surface 310. That is, in the pair of partition layers 31 facing each other, each of the extension portions 317, which include the inclined surface 313, approaches the other in the transverse direction of the fluidic channel portion 33. Therefore, the width between the inclined surfaces 313 of the pair of partition layers 31 becomes continuously narrower (decreases) toward the cover layer 12. That is, the width between the inclined surfaces 313 of the pair of partition layers 31 becomes continuously narrower (decreases) toward the cover layer 12.

The "continuously decreases" herein means that the fluidic channel width W22 of the fluidic channel portion 33 continuously decreases, without increasing, from a region between the upper ends of the flat surfaces 312 (region between the second intermediate ends 310d of the pair of partition layers 31) toward the bottom of the fluidic channel portion 33 (between the upper ends 310a of the pair of partition layers 31).

Thus, the width of the fluidic channel portion 33 (fluidic channel width W22) continuously decreases toward the substrate 10 in a region including the inclined surface 311 (region formed by the inclined surface 311) of the side surface 310 of the partition layer 31. Further, the fluidic channel width W22 continuously decreases toward the cover layer 12 in a region including the inclined surface 313 (region formed by the inclined surface 313) of the side surface 310 of the partition layer 31. Furthermore, the fluidic channel width W22 is constant in a region formed by the surface other than the inclined surface 311 and the inclined surface 313, that is, the flat surface 312 of the side surface 310 of the partition layer 31.

With this configuration, a region with the reduced fluidic channel width W22 can be limited to a region on the bottom side (substrate 10 side) of the fluidic channel portion 33, that is, between the inclined surfaces 311 and a region on the top side (cover layer 12 side) of the fluidic channel portion 33, that is, between the inclined surfaces 313. Accordingly, in the microfluidic chip 3, the areas of the bonding region for bonding the partition layer 31 and the substrate 10 and the bonding region for bonding the partition layer 31 and the cover layer 12 can be reliably increased, while maintaining the width of the fluidic channel width W22 of the fluidic channel portion 33 in a region between the flat surfaces 312 of the pair of partition layers 31. Therefore, the microfluidic chip 2 can reliably enhance adhesion between the partition layer 31 and the substrate 12 and between the partition layer 31 and the cover layer 12, while improving flow stability of a fluid (e.g., reaction solution) in the fluidic channel portion 33 and visibility during observation of the interior of the fluidic channel portion 33.

Further, as shown in Fig. 4, the fluidic channel portion 33 has a rounded corner shape in cross-sectional view. The "cross-section" in the "cross-sectional view" refers to a cross-section of the microfluidic chip 1 cut in the thickness direction (direction perpendicular to the longitudinal direction of the fluidic channel portion 3), and the cross-section includes the substrate 10, the partition layer 31, the cover layer 12 and the fluidic channel portion 33. Since the fluidic channel portion 33 has a rounded corner shape in cross-sectional view, a liquid flow speed and a flow rate of a fluid (e.g., reaction solution) in the fluidic channel portion 33 can be stabilized.

The shape of the partition layer 31 and the configuration of the fluidic channel portion 33 in the microfluidic chip 3 according to this modified example has been described. The basic configuration such as materials other than the shape of the partition layer 31, the thickness (fluidic channel height), and the width and fluidic channel length of the fluidic channel portion 33 are the same as those of the partition layer 11 and the fluidic channel portion 13 of the microfluidic chip 1 according to the first embodiment, and the description thereof will be omitted.

### (1.3.2.2) Method of producing microfluidic chip

The basic method of producing a microfluidic chip 2 according to this modified example is the same as the method of producing a microfluidic chip 1 according to the first embodiment described above (see Fig. 2), and detailed description will be omitted.

Moreover, in this modified example, the upper and lower parts of the partition layer 31 can be formed in a flared shape with the width increasing toward the cover layer 12 and the substrate 10, respectively, by adjusting the wavelength of ultraviolet light during exposure in the exposure step (step S3) and removing excess resin from the photosensitive resin layer in the development step (step S4).

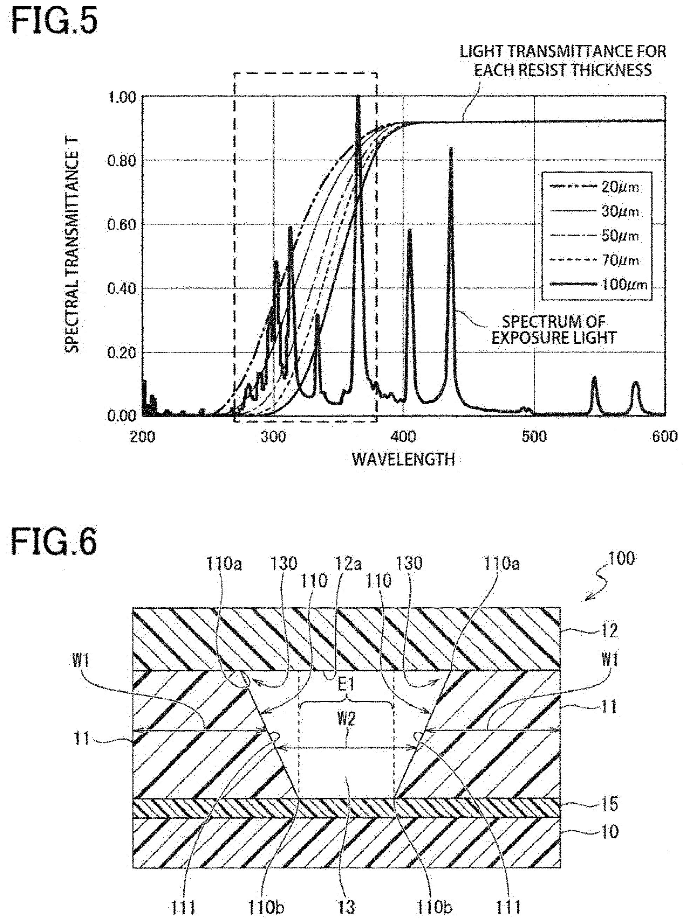

As an example, a case where the photosensitive resin layer for forming the partition layer 31 is formed of a negative resist will be described with reference to Fig. 5. Fig. 5 is a line graph showing the light transmittance (in this example, ultraviolet light transmittance) of a photosensitive resin layer formed of a negative resist for each film thickness (20 µm to 100 µm).

As shown in Fig. 5, when the light transmittance varies depending on the film thickness, the amount of exposure in the exposure step decreases relatively from the surface toward the inside of the photosensitive resin layer. Specifically, the amount of exposure to light (ultraviolet light) in a specific wavelength range indicated by the dotted line frame in Fig. 5 decreases toward the inside of the photosensitive resin layer. The light in the specific wavelength range described herein may correspond to, for example, ultraviolet light in the wavelength range of 250 nm or greater and 350 nm or less in the ultraviolet light region. For example, Fig. 5 shows that the transmittance to ultraviolet light in the specific wavelength range decreases as the film thickness of the photosensitive resin layer increases. In other words, the light transmittance of a portion with thin film thickness, that is, a surface portion (upper part) of the photosensitive resin layer, indicates that the amount of exposure is greater than in the inside (lower part) of the photosensitive resin layer.

The fact that the amount of exposure is greater in the upper part of the photosensitive resin layer indicates that the resin (negative resist) is more easily cured in the upper part of the photosensitive resin layer. Accordingly, more resin remains without being dissolved during development in the upper part of the photosensitive resin layer. Therefore, the width W21 of the partition layer 31 in the upper region 31a of the partition layer 31 can be increased toward the cover layer 12.

Also, by dissolving a resin on the lower side of the cured resin in the photosensitive resin layer and removing excess resin in development, the inclined surface 313 can be formed on the side surface 310 in the upper region 31a of the partition layer 31. Further, the inclined surface 313 can be formed in a curved shape in cross-sectional view by adjusting, for example, the development time and the concentration of the developer in development.

Furthermore, by adjusting the exposure direction of ultraviolet light or by focusing light emitted from the exposure device during exposure, the amount of exposure in the upper part of the photosensitive resin layer (negative resist layer) can be the same as that in the lower part. Accordingly, more resin remains without being dissolved during development in the upper and lower parts of the photosensitive resin layer. On the other hand, more resin is dissolved during development in the intermediate portion of the photosensitive resin layer where the amount of exposure is low, compared with the upper and lower parts, resulting in a smaller amount of resin remaining.

Accordingly, the width W21 of the partition layer 31 in the upper region 31a and the lower region 31b of the partition layer 31 can be increased toward the substrate 10. Further, the width W21 of the partition layer 31 can be smaller in the intermediate region 31c of the partition layer 31 than in each of the upper region 31a and the lower region 31b.

Also, by dissolving a resin on the upper side of the cured resin in the photosensitive resin layer and removing excess resin in development, the inclined surface 311 can be formed on the side surface 310 in the lower region 31b of the partition layer 31. Further, the inclined surface 311 can be formed in a curved shape in cross-sectional view by adjusting, for example, the development time and the concentration of the developer in development.

In addition, by dissolving a portion of the photosensitive resin layer in which the amount of exposure is low and curing has not progressed, and removing the excess resin, the flat surface 312 can be formed on the side surface 310 of the intermediate region 31c of the partition layer 31.

The present disclosure is not limited to the above examples, and the partition layer formed of the photosensitive resin layer may have a bilayer structure of a positive resist and a negative resist. Specifically, a positive resist is applied to the substrate 10, exposed and developed to form a lower flared-shape portion (lower region 31b). Then, a negative resist is applied to the lower flared-shape portion, exposed and developed to form an upper flared-shape portion (upper region 31a). Thus, the partition layer 31 may have a bilayer structure.

When forming the lower region 31b, in the region of the photosensitive resin layer formed of the positive resist on the substrate 10 side, the closer to the substrate 10, the lower the amount of exposure and the less the resin dissolves, and the closer to the substrate 10, the greater the amount of resin remaining during development. Further, when forming the upper region 31a, in the region of the photosensitive resin layer formed of the negative resist on the cover layer 12 side, the closer to the top, the higher the amount of exposure and the more the resin cures, and the closer to the top to which the cover layer 12 is bonded, the greater the amount of resin remaining. Accordingly, the upper region 31a of the partition layer 31 on the cover layer 12 side and the lower region 31b of the partition layer 31 on the substrate 10 side can be increased toward the cover layer 12 and the substrate 10, respectively (can be formed in a flared shape).

Also in this case, as described above, the curved inclined surface 313 can be formed by development in the upper region 31a of the partition layer 31, and the curved inclined surface 311 can be formed in the lower region 31b.

Further, the flat surface 312 can be formed by development on the side surface 310 of the intermediate region 31c of the partition layer 31.

As described above, in the method of producing a microfluidic chip 3 according to this modified example, in the step of exposing resin (step S3), the photosensitive resin is exposed to light having a wavelength of 250 nm or greater and 350 nm or less in the ultraviolet light region. Further, the inclined surface 311 curved in a concave shape in cross-sectional view with one end (lower end 310b) being in contact with the substrate 10 is formed by development on a part of the side surface 310 of the partition layer 31 (side surface 310 of the lower region 31b). Further, the second inclined surface curved in a concave shape in cross-sectional view with one end (upper end 310a) being in contact with the cover layer 12 is formed by development on the remaining portion of the side surface 310 of the partition layer 31 (side surface 310 of the upper region 31a).

Thus, the microfluidic chip 3 can be obtained in which the areas of the bonding region for bonding the partition layer 31 and the substrate 10 and the bonding region for bonding the partition layer 31 and the cover layer 12 can be increased, enhancing adhesion between the partition layer 31 and the substrate 10 and adhesion between the partition layer 31 and the cover layer 12.

### 2. Second Embodiment

### (2.1) Overview of microfluidic chip 100

With reference to Fig. 6, a microfluidic chip according to a second embodiment of the present disclosure will be described. Fig. 6 is a cross-sectional diagram illustrating an example configuration of a microfluidic chip 100 according to the second embodiment of the present disclosure.

The microfluidic chip 100 includes a substrate 10, an adhesive layer 15 disposed on the substrate 10, a partition layer 11 that defines a fluidic channel portion 13 on the substrate 10, and a cover layer 12. That is, the microfluidic chip 100 differs from the microfluidic chip 1 according to the first embodiment in that the adhesive layer 15 is provided between the partition layer 11 and the substrate 10.

### (2.2) Configuration of adhesive layer

The adhesive layer 15 will be described below. Components other than the adhesive layer 15 (substrate 10, partition layer 11, cover layer 12 and fluidic channel portion 13) have the same configuration as in the microfluidic chip 1, so the same reference signs are used and the description thereof will be omitted.

In the microfluidic chip 100, the substrate 10 may be subjected to hydrophobic surface treatment (HMDS treatment) or may be coated with a thin film of resin in order to further enhance adhesion between the substrate 10 and a resin layer (for example, photosensitive resin layer), that is, the partition layer 11. In particular, when glass or the like is used for the substrate 10, the adhesive layer 15 formed of a thin film may be provided between the substrate 10 and the partition layer 11 (photosensitive resin layer) as shown in Fig. 6. In this case, a fluid (for example, liquid) flowing through the fluidic channel portion 13 comes into contact with the adhesive layer 15 instead of the substrate 10. Therefore, the adhesive layer 15 may be resistant to the fluid introduced into the fluidic channel portion 13. The adhesive layer 15 provided on the substrate 10 can contribute to improving the resolution of the fluidic channel pattern of the photosensitive resin.

### (2.3) Modified Examples

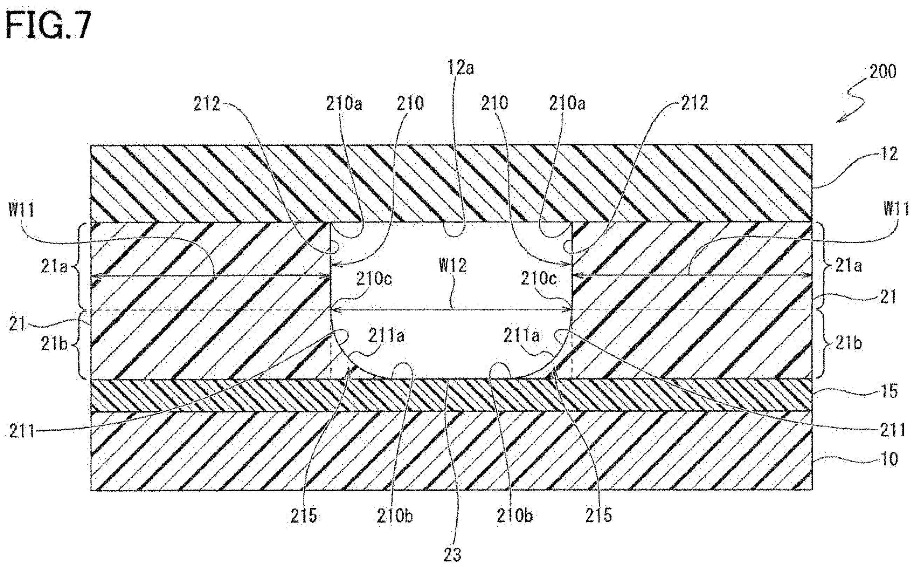

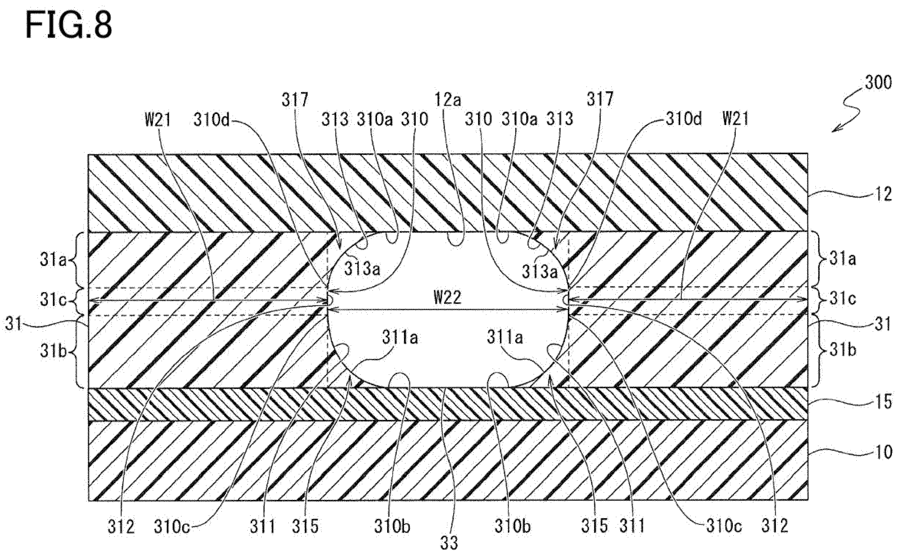

With reference to Figs. 7 and 8, a microfluidic chip according to a modified example of the present embodiment will be described.

### (2.3.1) First modified example

First, referring to Fig. 7, a configuration of a microfluidic chip 200 according to a first modified example of the present embodiment will be described. Fig. 7 is a schematic cross-sectional diagram illustrating an example configuration of the microfluidic chip 200 according to this modified example. The microfluidic chip 200 has a configuration in which an adhesive layer is added to the microfluidic chip 2 according to the first modified example of the first embodiment.

The microfluidic chip 200 includes a substrate 10, an adhesive layer 15 disposed on the substrate 10, a partition layer 21 that defines a fluidic channel portion 23 on the substrate 10, and a cover layer 12. That is, the microfluidic chip 200 differs from the microfluidic chip 2 according to the first modified example of the first embodiment in that the adhesive layer 15 is provided between the partition layer 21 and the substrate 10.

The adhesive layer 15 in this modified example is the same as the adhesive layer 15 in the microfluidic chip 100 according to the second embodiment described above, and the description thereof will be omitted. Providing the adhesive layer 15 can further enhance the adhesion between the substrate 10 and a resin layer (for example, photosensitive resin layer), that is, the partition layer 21 in the microfluidic chip 200.

### (2.3.2) Second modified example

Next, referring to Fig. 8, a configuration of a microfluidic chip 300 according to a second modified example of the present embodiment will be described. Fig. 8 is a schematic cross-sectional diagram illustrating an example configuration of the microfluidic chip 300 according to this modified example. The microfluidic chip 300 has a configuration in which an adhesive layer is added to the microfluidic chip 3 according to the second modified example of the first embodiment.

The microfluidic chip 300 includes a substrate 10, an adhesive layer 15 disposed on the substrate 10, a partition layer 31 that defines a fluidic channel portion 33 on the substrate 10, and a cover layer 12. That is, the microfluidic chip 300 differs from the microfluidic chip 2 according to the second modified example of the first embodiment in that the adhesive layer 15 is provided between the partition layer 31 and the substrate 10.

The adhesive layer 15 in this modified example is the same as the adhesive layer 15 in the microfluidic chip 100 according to the second embodiment described above, and the description thereof will be omitted. Providing the adhesive layer 15 can further enhance the adhesion between the substrate 10 and a resin layer (for example, photosensitive resin layer), that is, the partition layer 31 in the microfluidic chip 300.

### 3. Test Examples

In the following description, adhesion evaluation of the above microfluidic chip will be described using specific test examples.

The adhesion between the wall and the substrate in the microfluidic chip according to the first embodiment of the present disclosure and a conventional microfluidic chip can be easily assessed as follows, for example.

Although details will be described later, in this test example, a sample with a pillar pattern composed of a plurality of pillars (pillar-shaped resin structures), instead of fluidic channels, on a substrate was prepared as a sample for evaluating adhesion. Specifically, the adhesion evaluation sample had a configuration corresponding to a substrate on which a fluidic channel pattern before a cover layer was bonded was formed. In the adhesion evaluation sample of this test example, each pillar constituting the pillar pattern was regarded as a wall, and adhesion between the pillar and the substrate was assessed. Thus, simple evaluation of the adhesion between the wall and the substrate of the microfluidic chip was performed.

Test example 1 was simple evaluation of the adhesion between the wall and the substrate in the microfluidic chip according to the first embodiment of the present disclosure. Test example 2 was simple evaluation of the adhesion between the wall and the substrate in a conventional microfluidic chip.

### <Test Example 1>

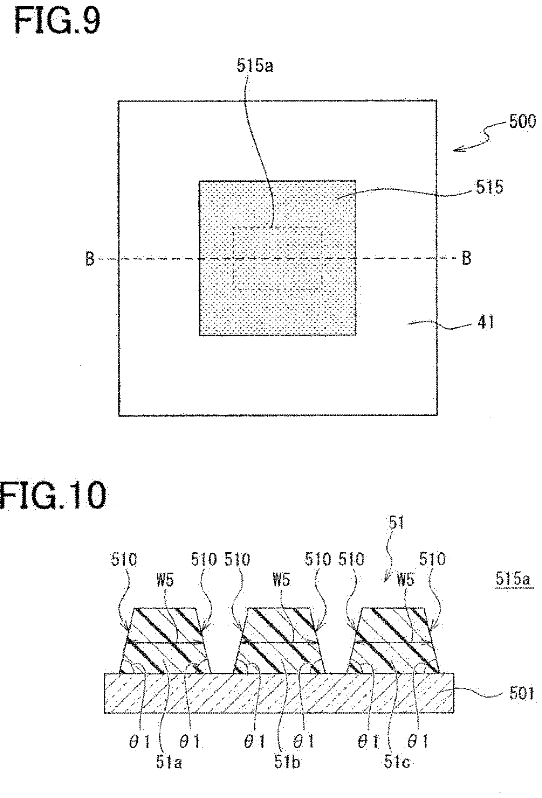

With reference to Figs. 9 and 10, an adhesion evaluation sample of Test example 1 will be described.

Fig. 9 is a schematic plan view illustrating a schematic configuration of an adhesion evaluation sample 500 of Test example 1. Fig. 10 is a schematic cross-sectional diagram illustrating an enlarged partial cross-section of the evaluation sample 500 taken along the line B-B shown in Fig. 9 in the thickness direction. Specifically, Fig. 10 is a schematic cross-sectional diagram of a part (region 515a) of a pattern region 515, which will be described later, of the evaluation sample 500.

In Test example 1, steps corresponding to steps S1 to S6 in the production method of the first embodiment were performed. Accordingly, an evaluation sample 500 was prepared in which a pillar pattern corresponding to the fluidic channel pattern before the cover layer was bonded was formed on the substrate, and evaluation of the adhesion properties of the sample was performed. That is, using the evaluation sample 500 having a configuration corresponding to the microfluidic chip according to the first embodiment, simple evaluation of the adhesion between the wall and the substrate was performed.

As shown in Figs. 9 and 10, in the adhesion evaluation sample 500 of Test example 1, a photosensitive resin layer 41 was formed on a glass substrate 501. Further, a pillar pattern 51 was formed in a rectangular pattern region 515 of the photosensitive resin layer 41 on the glass substrate 501. As shown in Fig. 9, the pattern region 515 corresponds to a center region of the photosensitive resin layer 41 in plan view of the evaluation sample 500. In Fig. 9, the pattern region 515 in which the pillar pattern 51 composed of a plurality of pillars is formed is indicated by hatching.

As shown in Fig. 10, in the adhesion evaluation sample 500 of Test example 1, the pillars constituting the pillar pattern 51 (in this example, pillars 51a, 51b and 51c) had a shape with a pattern width W5 increasing toward the substrate in cross-sectional view, that is, a shape corresponding to the partition layer 11 of the microfluidic chip 1 of the first embodiment. In the pillar pattern 51, other pillars which are not shown also had the same shape as the pillars 51a, 51b and 51c.

The method of producing the evaluation sample 500 will be specifically described below.

### [Sample Preparation]

A positive resist was applied as a photosensitive resin to the glass substrate 501 to form a photosensitive resin layer 41. The positive resist was applied by spin coating, and the rotation speed was adjusted so that the film thickness of the photosensitive resin layer 41 became 50 µm.

Next, heat treatment (pre-baking) was performed on a hot plate in order to remove residual solvent contained in the photosensitive resin layer 41. The pre-baking was performed at a temperature of 90°C for 20 minutes.

Next, the photosensitive resin layer 41 applied to the glass substrate 501 was exposed to light to draw the pillar pattern 51 in the pattern region 515 for use in adhesion evaluation. The exposure conditions for drawing the pillar pattern 51 were adjusted so that the pattern width W5 increased toward the glass substrate 501, and a pattern side surface 510 had an internal angle of 75° relative to the glass substrate 501. Specifically, in the photomask used to draw the pillar pattern 51, the exposure conditions were adjusted so that the exposure intensity was 0% inside a 30 µm-diameter circle, 100% outside a 56.8 µm-diameter circle having the same center position as the 30 µm-diameter circle, and linearly changed from 0% to 100% in a region between circumferences of these two circles from the inside to the outside.

With the above exposure conditions, the pillar pattern 51 in the evaluation sample 500 of Test example 1 had a configuration in which a plurality of pillars having a 30 µm-diameter circular shape in plan view were arranged in a square at a pitch of 60 µm in the 24 mm × 24 mm rectangular pattern region 515.

Next, the exposed photosensitive resin layer 41 was subjected to development. In the development, an alkaline developer was (TMAH 2.38%) was used.

Next, cleaning was performed with ultra-pure water to remove the developer from the photosensitive resin layer 41 on the glass substrate 501, and then drying was performed with a spin dryer.

Thus, the adhesion evaluation sample 500 of Test example 1 provided with the pillar pattern 51 having the shape corresponding to the partition layer 11 of the microfluidic chip 1 according to the first embodiment was prepared.

In Fig. 10, some of the pillars (pillar 51a, 51b and 51c) among a plurality of pillars arranged in a square in the pattern region 515 of the evaluation sample 500 are shown enlarged for ease of understanding. As shown in Fig. 10, each of the pillars 51a, 51b and 51c constituting the pillar pattern 51 was formed, under the above exposure conditions, so that the pattern width W5, which was the width of each pillar, increased toward the glass substrate 501 in cross-sectional view. That is, each pillar had a tapered shape (width W5 decreasing from the glass substrate 501 upward). More specifically, the pattern side surface 510 had an angle θ, which was the internal angle relative to the glass substrate 501, of 75°.

### <Test Example 2>

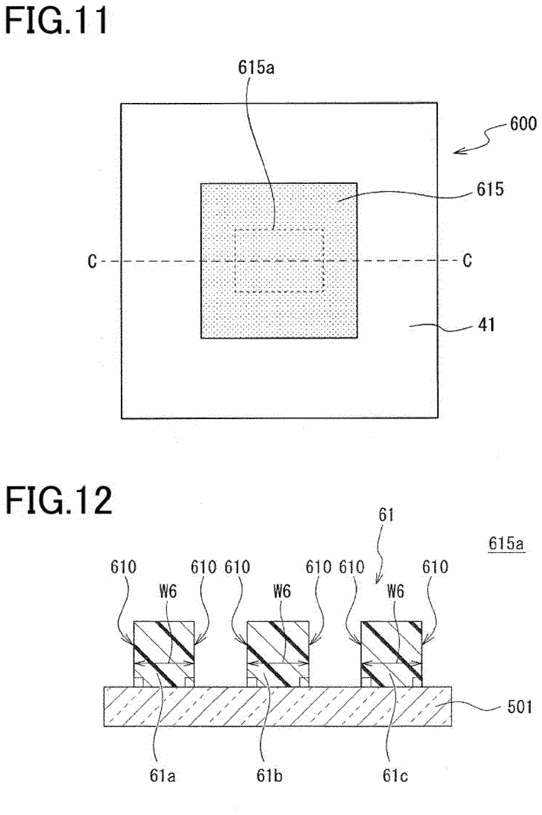

With reference to Figs. 11 and 12, an adhesion evaluation sample of Test example 2 will be described.

Fig. 11 is a schematic plan view illustrating a schematic configuration of an adhesion evaluation sample 600 of Test example 2. Fig. 12 is a schematic cross-sectional diagram illustrating an enlarged partial cross-section of the evaluation sample 600 taken along the line C-C shown in Fig. 11 in the thickness direction. Specifically, Fig. 12 is an enlarged schematic cross-sectional diagram of a part (region 615a) of a pattern region 615, which will be described later, of the evaluation sample 600.

As shown in Figs. 11 and 12, the adhesion evaluation sample 600 of Test example 2 was the same as the evaluation sample 500 of Test example 1 in that the photosensitive resin layer 41 was formed on the glass substrate 501. Meanwhile, the evaluation sample 500 of Test example 1 differs from the evaluation sample 600 of Test example 2 in the form of the pillar pattern.

In the evaluation sample 600, a pillar pattern 61 was formed in a rectangular pattern region 615 of the photosensitive resin layer 41 on the glass substrate 501. As shown in Fig. 11, the pattern region 615 corresponds to a center region of the photosensitive resin layer 41 in plan view of the evaluation sample 600. In Fig. 11, the pattern region 615 in which the pillar pattern 61 composed of a plurality of pillars is formed is indicated by hatching.

As shown in Fig. 12, in the adhesion evaluation sample 600 of Test example 2, the pillars constituting the pillar pattern 61 had a shape different from the pillars of the evaluation sample 500 of Test example 1 (see Fig. 10), that is, a shape corresponding to a partition layer of a conventional microfluidic chip. Specifically, the pillars (in this example, pillars 61a, 61b and 61c) of the evaluation sample 600 had a shape with a constant pattern width W6 in cross-sectional view. In the pillar pattern 61, other pillars which are not shown also had the same shape as the pillars 61a, 61b and 61c.

### [Sample Preparation]

In preparation of the evaluation sample 600 of Test example 2, the exposure conditions for drawing the pillar pattern 61 were adjusted so that the pillars (for example, pillars 61a, 61b and 61c) constituting the pillar pattern 61 had a pattern side surface 610 perpendicular to the substrate 10 in cross-sectional view. In the photomask used to draw the pillar pattern 61, the exposure conditions were specifically adjusted so that the exposure intensity was 0% inside a 30 µm-diameter circle and 100% outside the circle. The evaluation sample 600 of Test example 2 was prepared in the same manner as with the evaluation sample 500 of Test example 1 except for the above exposure conditions.

With the above exposure conditions, the pillar pattern 61 in the evaluation sample 600 of Test example 2 had a configuration in which a plurality of pillars having a 30 µm-diameter circular shape in plan view were arranged in a square at a pitch of 60 µm in the 24 mm × 24 mm rectangular pattern region 615.
Thus, the adhesion evaluation sample 600 of Test example 2 provided with the pillar pattern 61 having the shape corresponding to the wall (partition layer) of a conventional microfluidic chip was prepared.

In Fig. 12, some of the pillars (pillar 61a, 61b and 61c) among a plurality of pillars arranged in a square in the pattern region 615 of the evaluation sample 600 are shown enlarged for ease of understanding. As shown in Fig. 12, each of the pillars 61a, 61b and 61c constituting the pillar pattern 61 was formed, under the above exposure conditions, so that the pattern width W6, which was the width of each pillar, was constant toward the substrate in cross-sectional view. More specifically, each of the pillars 61a, 61b and 61c of the pillar pattern 61 was formed in the shape in which the pattern side surface 610 had a right-angled internal angle relative to the glass substrate 501 in cross-sectional view, that is, the pattern side surface 610 was perpendicular to the glass substrate 501.

### [Adhesion Evaluation]

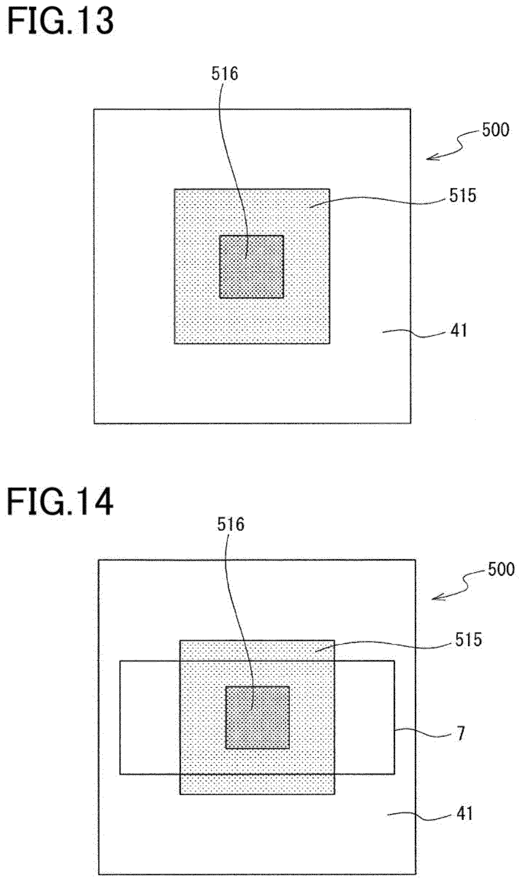

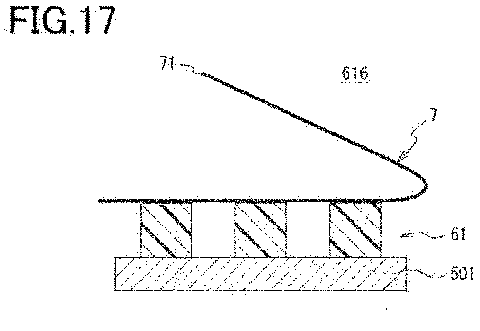

With reference to Figs. 13 and 17, the adhesion test and evaluation for the adhesion evaluation samples 500 and 600 of Test examples 1 and 2 will be described.

### <Adhesion Test of Test Example 1>

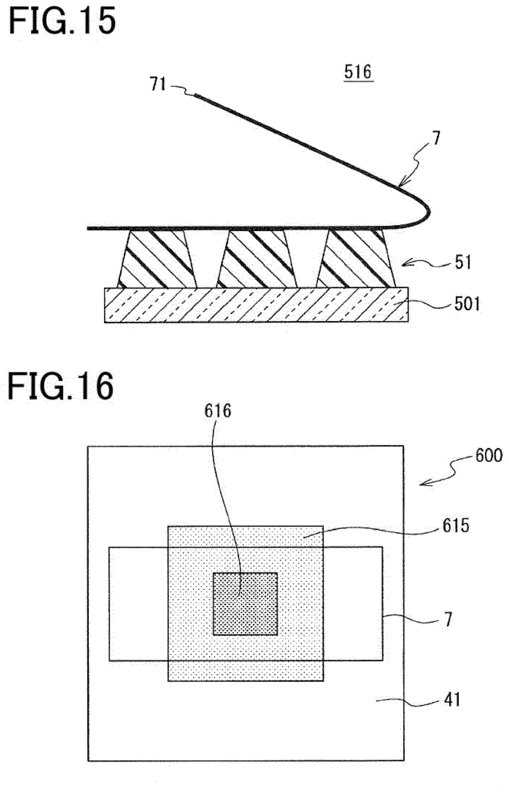

With reference to Figs. 13 to 15, the adhesion evaluation of Test example 1 will be described. Fig. 13 is a schematic plan view of a region (cut region 516, described later) in which test cuts are made in the evaluation sample 500. Fig. 14 is a schematic plan view illustrating an adhesion test method for the evaluation sample 500 of Test example 1. Fig. 15 is a schematic cross-sectional diagram illustrating an adhesion test method for the evaluation sample 500 of Test example 1.

In this test, as shown in Fig. 13, a Sellotape (registered trademark) peel test was performed on the cut region 516, which was a region on a part of the pattern region 515 in which the pillar pattern was formed in the evaluation sample 500.

Specifically, cuts were made in the cut region 516 of the evaluation sample 500 using a cross hatch cutter (cc3000). The cut region 516 was a rectangular region of approximately 10 mm × 10 mm. In the cut region 516, cuts were formed in two directions perpendicular to each other in plan view, as in the typical cross cutting test (for example, JIS K 5600). Further, the depth of the cuts in the cut region 516 was the same as the thickness (50 µm) of the photosensitive resin layer 41.

Next, as shown in Fig. 14, Sellotape 7 (CRCT-18) was attached to cover the region in which the cuts were made, that is, the cut region 516, in the pattern region 515 in which the pillar pattern 51 was formed. More specifically, the Sellotape 7 was attached and rubbed with a finger for adhesion along one of the two directions of the cuts in the cut region 516. Fig. 14 illustrates the state in which the Sellotape 7 adhered to the cut region 516 in the adhesion evaluation sample 500 of Test example 1 shown in Fig. 13.

Fig. 15 is a schematic cross-sectional diagram illustrating an enlarged cross-section of a part of the cut region 516 to which the Sellotape 7 adhered. As shown in Fig. 15, the Sellotape was attached so that it adhered to the top of the pillars of the pillar pattern 51, and 1 minute after adhesion, an experimenter held a tape edge 71, which was an edge of the Sellotape 7, by hand, and quickly (within 1 second) peeled the Sellotape 7 from the cut region 516 upward at an angle of approximately 60° relative to the surface of the glass substrate 501.

Then, the pillar pattern 51 on the glass substrate 501 after the Sellotape 7 was peeled off was observed with an optical microscope (FPD/LSI inspection microscope) in a bright field mode, using a 1x objective lens, and the observation image was captured.

The observation image captured by the above optical microscope was subjected to image processing to obtain an image of a region of approximately 9 mm × 9 mm, excluding the outer periphery of the cut region 516 of the evaluation sample 500 on which the peel test with the Sellotape 7 was performed. For the captured image, the area of the entire region of approximately 9 mm × 9 mm (total area) and the area of the portion where the pillar pattern 51 was detached after the Sellotape 7 was peeled off (detached area) were determined. Further, the area ratio of the detached area to the total area was calculated.

In this test, in the above captured image of the cut region 516 in the adhesion evaluation sample 500 of Test example 1, the ratio of the detached area where the pillar pattern 51 was detached after the Sellotape 7 was peeled off to the total area was 21.3%.

### <Adhesion Test of Test Example 2>

With reference to Figs. 16 to 17, the adhesion evaluation of Test example 2 will be described. Fig. 16 is a schematic plan view illustrating an adhesion test method for the evaluation sample 600 of Test example 2. Fig. 17 is a schematic cross-sectional diagram illustrating an adhesion test method for the evaluation sample 600 of Test example 1.

In this test, as shown in Fig. 16, a Sellotape peel test was performed on a region 616, which was a region on a part of the pattern region 615 in which the pillar pattern was formed in the evaluation sample 600 of Test example 2. The Sellotape peel test was performed by the same method as in the Sellotape peel test for the evaluation sample 500 of Test example 1.

Specifically, as in the cut region 516 of the evaluation sample 500, cuts were made in two directions perpendicular to each other in plan view in the cut region 616 of the evaluation sample 600 using a cross hatch cutter (cc3000). The depth of the cuts in the cut region 616 was 50 µm as in Test example 1. Further, Sellotape 7 (CRCT-18) was attached to cover the cut region 616 in the pattern region 615 in which the pillar pattern 61 was formed. More specifically, the Sellotape 7 was attached and rubbed with a finger for adhesion along one of the two directions of the cuts in the cut region 616 (the same direction as in Test example 1). Fig. 16 illustrates the state in which the Sellotape 7 adhered to the cut region 616 in the adhesion evaluation sample 600 of Test example 2.

Fig. 17 is a schematic cross-sectional diagram illustrating an enlarged cross-section of a part of the cut region 616 to which the Sellotape 7 adhered. As shown in Fig. 17, the Sellotape was attached so that it adhered to the top of the pillars of the pillar pattern 61, and 1 minute after adhesion, an experimenter held an edge 71 of the Sellotape 7 by hand, and quickly (within 1 second) peeled the Sellotape 7 from the cut region 616 upward at an angle of approximately 60° relative to the surface of the glass substrate 501.

Then, for the cut region 616 of the evaluation sample 600 after the Sellotape was peeled off, an observation image was prepared in the same manner as in Test example 1. Specifically, as in the Sellotape peel test of Test example 1, the pillar pattern 61 on the glass substrate 501 after the Sellotape 7 was peeled off was observed with an optical microscope in a bright field mode, using a 1x objective lens, and the observation image was captured.

In Test example 2, the above observation image was subjected to image processing, as with the observation image of Test example 1, to obtain an image of a region of approximately 9 mm × 9 mm, excluding the outer periphery of the cut region 616. For the captured image, the total area (region of approximately 9 mm × 9 mm) and the area of the portion where the pillar pattern 61 was detached after the Sellotape 7 was peeled off (detached area) were determined. Further, the area ratio of the detached area to the total area was calculated.

In this test, in the above captured image of the cut region 616 in the adhesion evaluation sample 600 of Test example 2, the ratio of the detached area where the pillar pattern 61 was detached after the Sellotape 7 was peeled off to the total area was 39.7%.

As described above, as a result of the Sellotape peel test performed on the adhesion evaluation samples 500 and 600 of Test examples 1 and 2, the ratio of the detached area where the pillar pattern was detached from the glass substrate 501 was smaller in the evaluation sample 500 of Test example 1 than in the evaluation sample 600 of Test example 2. In other words, the evaluation sample 500 of Test example 1 was found to have higher adhesion to the glass substrate 501 than the evaluation sample 600 of Test example 2.

In other words, as seen from the above test examples, the patterned photosensitive resin layer was found to have higher adhesion to the substrate when the wall (partition layer 11) had a shape (tapered shape) with the pattern side surface having an internal angle of less than 90° (75° in Test example 1) relative to the glass substrate 501 as in the microfluidic chip 1 according to the first embodiment compared with when the wall had a shape (shape with a constant pattern width) with the pattern side surface being perpendicular to the substrate as in the conventional microfluidic chip.

### [Industrial Applicability]

The present disclosure can be suitably used for microfluidic chips for research applications, diagnostic applications, testing, analysis, culture, and the like, which do not require complicated production processes to form a top lid, and methods of producing the same.

### [Reference Signs List]

1, 2, 3, 100, 200, 300... Microfluidic chip
4 ... Inlet
5 ... Outlet
7 ... Cellophane tape
10 ... Substrate
11, 21, 31 ... Partition layer
12 ... Cover layer
13, 23, 33 ... Fluidic channel portion
15 ... Adhesive layer
41 ... Photosensitive resin layer
51, 61 ... Pillar pattern
71 ... Tape edge
110, 210, 310 ... Side surface
111, 211, 311, 313 ... Inclined surface
130 ... Bubble trapping region
212, 312 ... Flat surface
215, 315, 317 ... Extension portion
500, 600 ... Evaluation sample
501 ... Glass substrate
510, 610 ... Pattern side surface
515, 615 ... Pattern region
516, 616 ... Cut region

## Claims

1. A microfluidic chip comprising:
a substrate;
a partition member made of a resin material, the partition member being disposed on the substrate and defining a fluidic channel; and
a cover member disposed on a side of the partition member opposite to that facing the substrate, the cover member covering the fluidic channel, wherein
the partition member has a width which increases toward the substrate in cross-sectional view.

2. The microfluidic chip according to claim 1, wherein
the partition member has an inclined surface provided on a side surface that defines the fluidic channel, the inclined surface being inclined relative to the substrate.

3. The microfluidic chip according to claim 2, wherein
the inclined surface has a planar shape and is provided on the entire side surface of the partition member.

4. The microfluidic chip according to claim 3, wherein
the fluidic channel has a width which continuously decreases toward the substrate.

5. The microfluidic chip according to claim 3 or 4, wherein
the fluidic channel includes a bubble trapping region that traps air bubbles in the fluidic channel, and
the bubble trapping region is formed by the inclined surface of the partition member and a surface of the cover member on the fluidic channel side.

6. The microfluidic chip according to claim 2, wherein
the inclined surface is formed on a part of the side surface of the partition member, the inclined surface being curved in a concave shape in cross-sectional view, and
one end of the inclined surface is connected to the substrate.

7. The microfluidic chip according to claim 6, wherein
the partition member includes an extension portion which includes the curved inclined surface and extends in a transverse direction of the fluidic channel along a surface of the substrate, and
the extension portion has a thickness which decreases in transverse direction of the fluidic channel.

8. The microfluidic chip according to claim 6 or 7, wherein
the width of the fluidic channel continuously decreases toward the substrate in a region formed by the curved inclined surface of the side surface of the partition member, and is constant in a region formed by a surface of the side surface other than the inclined surface.

9. The microfluidic chip according to any one of claims 6 to 8, wherein
the partition member includes a first inclined surface which is the curved inclined surface, and a second inclined surface provided on a remaining portion of the side surface, the second inclined surface being curved in a concave shape in cross-sectional view,
one end of the second inclined surface is in contact with the cover member,
the width of the fluidic channel continuously decreases toward the substrate in a region including the first inclined surface of the side surface of the partition member, continuously decreases toward the cover member in a region including the second inclined surface of the side surface, and is constant in a region formed by a surface of the side surface other than the first inclined surface and the second inclined surface.

10. The microfluidic chip according to any one of claims 1 to 9, wherein
an adhesive layer is provided between the partition member and the substrate.

11. The microfluidic chip according to any one of claims 1 to 10, wherein
the resin material constituting the partition member is photosensitive resin that is photosensitive to light having a wavelength of 190 nm or greater and 400 nm or less in the ultraviolet light region.

12. A method of producing a microfluidic chip, comprising the steps of:
applying a resin to a substrate; exposing the applied resin to light;
subjecting the exposed resin to development and cleaning to thereby form a partition member that defines a fluidic channel on the substrate;
post-baking the partition member; and
bonding a cover member to a side of the partition member opposite to that facing the substrate, wherein
excess resin on the substrate is removed by the development, whereby the partition member is formed to have a width which increases toward the substrate in cross-sectional view.

13. The method of producing a microfluidic chip according to claim 12, wherein
an inclined surface is formed by the development on a side surface of the partition member that defines the fluidic channel, the inclined surface being inclined relative to the substrate.

14. The method of producing a microfluidic chip according to claim 13, wherein
an inclined surface having a planar shape is formed by the development on the entire side surface of the partition member.

15. The method of producing a microfluidic chip according to claim 13, wherein
the inclined surface is formed by the development on a part of the side surface of the partition member, the inclined surface being curved in a concave shape in cross-sectional view, and one end of the inclined surface being connected to the substrate.

16. The method of producing a microfluidic chip according to claim 15, wherein
in the step of exposing the resin, the photosensitive resin is exposed to light having a wavelength of 250 nm or greater and 350 nm or less in the ultraviolet light region, and
a first inclined surface which is the curved inclined surface is formed by the development, and a second inclined surface is formed on a remaining portion of the side surface of the partition member, the second inclined surface being curved in a concave shape in cross-sectional view, and one end of the second inclined surface being connected to the cover member.
